# EUROPEAN PATENT SPECIFICATION

(11) **EP 4 199 482 B1**
(45) Date of publication and mention of the grant of the patent: **13.11.2024**
(21) Application number: 21858459.7
(22) Date of filing: 24.06.2021
(51) Int. Cl.: H04M 1/02, F16C 11/04, G06F 1/16

(54) **ELECTRONIC DEVICE COMPRISING HINGE MODULE**
ELEKTRONISCHE VORRICHTUNG MIT SCHARNIERMODUL
DISPOSITIF ÉLECTRONIQUE COMPRENANT UN MODULE DE CHARNIÈRE

(30) Priority: 21.08.2020 KR 20200105358
(43) Date of publication of application: 21.06.2023
(73) Proprietor: Samsung Electronics Co., Ltd., Suwon-si, Gyeonggi-do 16677 (KR)
(72) Inventor: KIM, Jongyoon, Suwon-si, Gyeonggi-do 16677 (KR); KIM, Jongkeun, Suwon-si, Gyeonggi-do 16677 (KR)
(74) Representative: Gulde & Partner
(86) International application number: PCT/KR2021/007933
(87) International publication number: WO 2022/039371

(56) References cited:
- EP-A1- 4 040 762
- CN-A- 110 995 892
- KR-A- 20180 010 557
- KR-A- 20190 097 898
- KR-A- 20190 110 244
- US-A1- 2016 150 657
- US-A1- 2017 351 303
- US-B1- 9 677 308

## Description

### [Technical Field]

Various embodiments of the invention relate to an electronic device including a hinge module.

### [Background Art]

With the development of information and communication technology and semiconductor technology, various functions are being integrated into one portable electronic device. For example, an electronic device may implement not only communication functions but also entertainment functions, such as playing games, multimedia functions, such as playing music and videos, communication and security functions for mobile banking, and scheduling and e-wallet functions. Such electronic devices become compact enough for users to carry in a convenient way.

As mobile communication services extend up to multimedia service sectors, electronic devices require a larger display to allow users satisfactory use of multimedia services as well as voice call or text messaging services. This, however, trades off the trend of electronic devices being compact.

KR 2019 0097898 A, US 201 6/1 50657 A1, and CN 110 995 892 A disclose electronic devices including a conventional hinge module.

### [Detailed Description of the Invention]

### [Technical Problem]

An electronic device (e.g., a portable terminal) includes a display with a flat surface or both a flat and curved surface. An electronic device including a display may have a limitation in realizing a screen larger than the size of the electronic device due to the fixed display structure. Accordingly, research has been conducted on electronic devices including a foldable or rollable display.

In implementing a foldable electronic device, it may be difficult to secure mechanical stability while enabling structures of the electronic device to move relative to one another (e.g., slide, rotate, or pivot). For example, it may be hard to secure a stable operation structure while securing or maintaining portability by downsizing or slimming down foldable electronic devices.

According to various embodiments of the invention, there may be provided an electronic device including a hinge module capable of stably implementing the folding or unfolding of housings.

According to various embodiments of the invention, there may be provided an electronic device capable of stably maintaining the folded state or unfolded state of the housing.

The invention is defined by the appended set of claims. The description that follows is subjected to this limitation. Any disclosure lying outside the scope of said claims is only intended for illustrative as well as comparative purposes..

### [Technical Solution]

According to various embodiments of the invention, an electronic device comprises a first housing, a second housing, a flexible display received in the first housing and the second housing, and a hinge module connecting the first housing and the second housing. The hinge module includes a hinge bracket, a first rotation bracket connected with the first housing and rotatably mounted on the hinge bracket, a second rotation bracket connected with the second housing and rotatably mounted on the hinge bracket, a first interlocking member including a first gear shaft having at least a portion received in the hinge bracket, and having at least a portion positioned on the first rotation bracket, a second interlocking member including a second gear shaft connected with the first gear shaft and having at least a portion received in the hinge bracket, and having at least a portion positioned on the second rotation bracket, a first guide member connected with the first rotation bracket and configured to provide an elastic force to the first interlocking member in a first direction perpendicular to the flexible display, and a second guide member connected with the second rotation bracket and configured to provide an elastic force to the second interlocking member in the first direction.

### [Advantageous Effects]

The hinge module of the electronic device according to various embodiments of the invention may enable the pair of housings to interlock with each other using the interlocking member which receives elastic force in the height direction of the electronic device. As the folding direction of the electronic device is the same as the direction of receiving the elastic force of the interlocking member, the load on the interlocking member may be reduced, and the durability of the hinge module when the electronic device is folded may be increased.

According to various embodiments of the invention, the electronic device may stably maintain the unfolded state at the user's desired angle or a designated angle using the stopper structure capable of providing elastic force to the hinge module.

### [Brief Description of the Drawings]

FIG. 1 is a view illustrating an unfolded state of an electronic device according to various embodiments of the invention;
FIG. 2 is a view illustrating a folded state of an electronic device according to various embodiments of the invention;
FIG. 3 is a perspective view illustrating an electronic device according to various embodiments of the invention;
FIG. 4 is a view illustrating a connected structure of a first housing and a second housing in an electronic device according to various embodiments of the invention;
FIG. 5 is a view illustrating a structure in which a hinge module is disposed in an electronic device according to various embodiments of the invention;
FIG. 6 is a perspective view illustrating a hinge module according to various embodiments of the invention;
FIG. 7 is an exploded perspective view illustrating a hinge module according to various embodiments of the invention;
FIG. 8 is a plan view illustrating a hinge module according to various embodiments of the invention;
FIG. 9 is a perspective view illustrating a hinge bracket according to various embodiments of the invention;
FIG. 10 is a perspective view illustrating a portion of a second rotation bracket according to various embodiments of the invention;
FIG. 11 is a view illustrating a guide member positioned on a rotation bracket according to various embodiments of the invention;
FIG. 12 is a view illustrating a positional relationship between rotation axes and/or interlocking axes of an electronic device and/or a hinge module;
FIG. 13 is a perspective view illustrating an unfolded state of a hinge module according to various embodiments of the invention;
FIG. 14 is a view taken along line 'CA' of FIG. 13;
FIG. 15 is a perspective view illustrating an intermediate state of a hinge module according to various embodiments of the invention;
FIG. 16 is a view taken along line 'CB' of FIG. 15;
FIG. 17 is a perspective view illustrating a folded state of a hinge module according to various embodiments of the invention;
FIG. 18 is a view taken along plane `CC' of FIG. 17;
FIG. 19 is a view illustrating a hinge module including a stopper structure according to various embodiments of the invention;
FIGS. 20, 21, and 22 are perspective views illustrating operations of a hinge module according to the angle of an electronic device according to various embodiments of the invention;
FIGS. 23 and 24 are perspective views illustrating operations of a stopper structure according to the angle of an electronic device according to various embodiments of the invention;
FIG. 25 is a view illustrating a stopper ball and a guide hole according to various embodiments of the invention;
FIG. 26 is a plan view illustrating a hinge module including a second fixing portion according to various embodiments of the invention;
FIG. 27 is a front view illustrating a stopper structure in an unfolded state according to various embodiments of the invention;
FIG. 28 is a perspective view illustrating a stopper structure in an intermediate state according to various embodiments of the invention; and
FIG. 29 is a front view illustrating a stopper structure in a folded state according to various embodiments of the invention.

### [Mode for Carrying out the Invention]

The electronic device according to various embodiments of the disclosure may be one of various types of electronic devices. The electronic devices may include, for example, a portable communication device (e.g., a smartphone), a computer device, a portable multimedia device, a portable medical device, a camera, a wearable device, or a home appliance. According to an embodiment of the disclosure, the electronic devices are not limited to those described above.

With regard to the description of the drawings, similar reference numerals may be used to refer to similar or related elements. It is to be understood that a singular form of a noun corresponding to an item may include one or more of the things, unless the relevant context clearly indicates otherwise. As used herein, each of such phrases as "A or B," "at least one of A and B," "at least one of A or B," "A, B, or C," "at least one of A, B, and C," and "at least one of A, B, or C," may include all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

As used herein, the term "module" may include a unit implemented in hardware, software, or firmware, and may interchangeably be used with other terms, for example, "logic," "logic block," "part," or "circuitry". A module may be a single integral component, or a minimum unit or part thereof, adapted to perform one or more functions. For example, according to an embodiment, the module may be implemented in a form of an application-specific integrated circuit (ASIC).

According to various embodiments, each component (e.g., a module or a program) of the above-described components may include a single entity or multiple entities. According to various embodiments, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to various embodiments, operations performed by the module, the program, or another component may be carried out sequentially, in parallel, repeatedly, or heuristically, or one or more of the operations may be executed in a different order or omitted, or one or more other operations may be added.

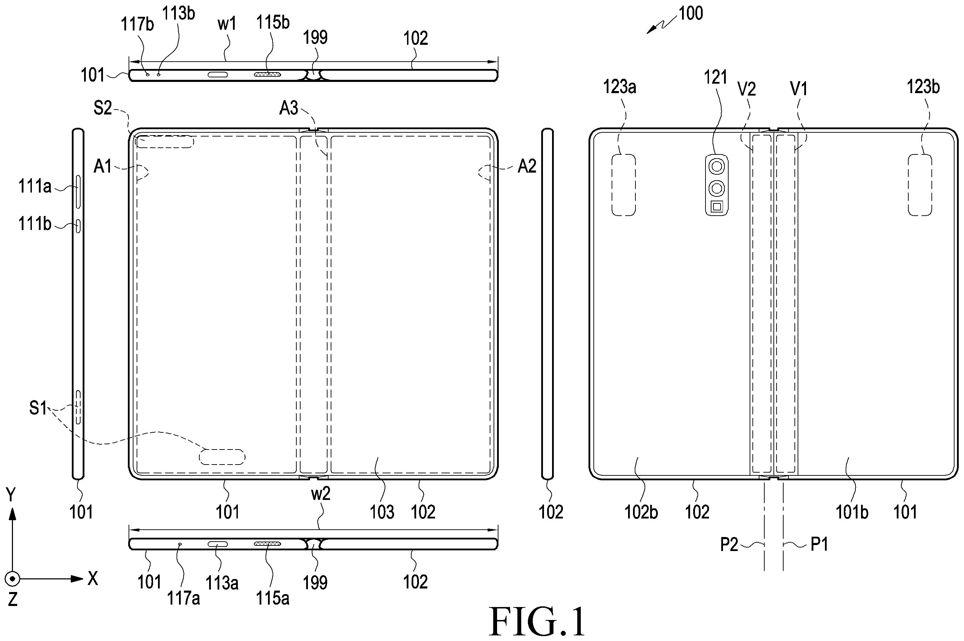

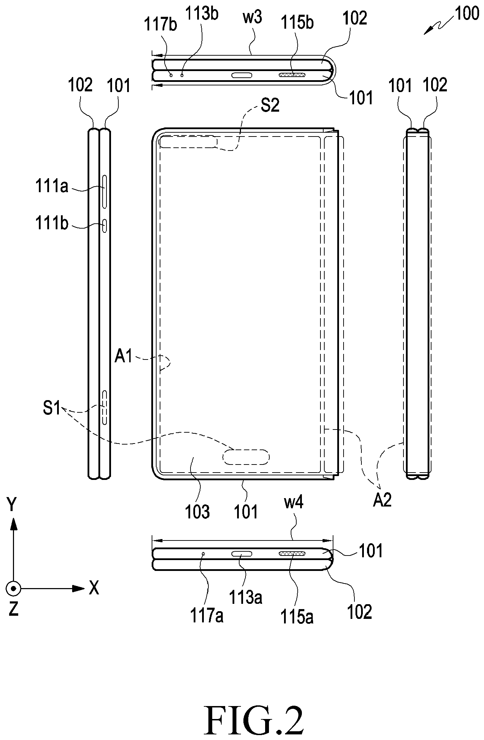

FIG. 1 is a view illustrating an unfolded state of an electronic device according to various embodiments of the invention. FIG. 2 is a view illustrating a folded state of an electronic device according to various embodiments of the invention.

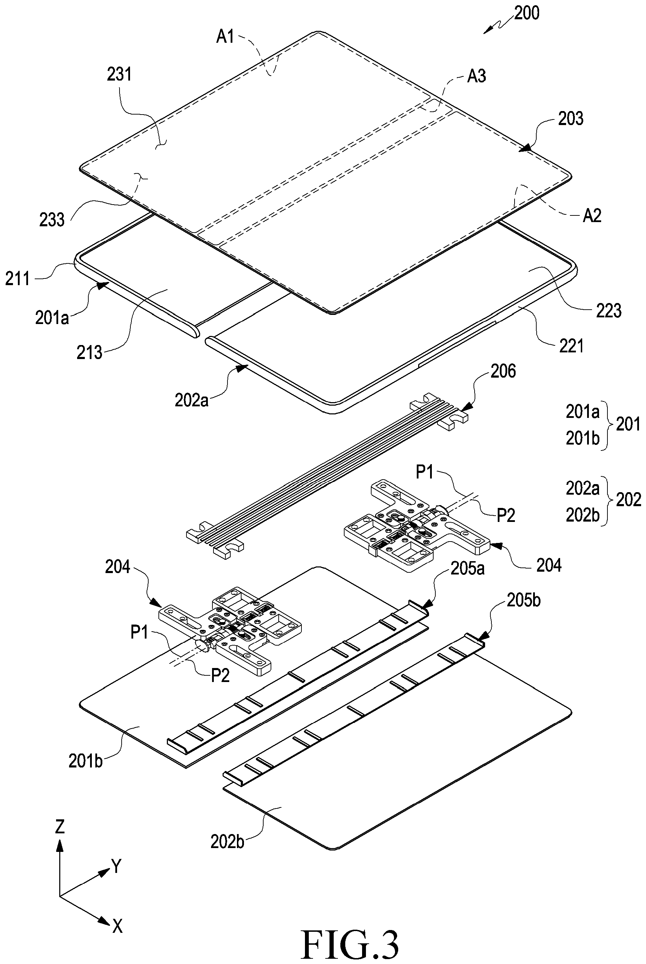

In describing various embodiments of the invention, a pair of housings (e.g., a first housing 101 and a second housing 102) are rotatably coupled to a hinge module (e.g., the hinge module 204 in FIG. 3). However, it should be noted that the electronic device 100 according to various embodiments of the invention is not limited thereto. For example, according to an embodiment, the electronic device 100 may include a plurality of housings. As used herein, a "pair of housing structures" may mean two rotatably-coupled housings among the plurality of housings. According to an embodiment, the first housing 101 and the second housing 102 may be defined as foldable housings.

In the following detailed description, "+X/-X-axis direction", "+Y/-Y direction" or "+Z/-Z direction" may be mentioned, and it should be noted that it is described based on the width direction (X-axis direction), the length direction (Y-axis direction), or the thickness direction (Z-axis direction) of the first housing 101 in FIG. 1 or 2. For example, various changes may be made to the above definitions according to embodiments or when another structure of the electronic device 100 is set as the reference. Further, in the following detailed description, `front surface' or `rear surface' may be mentioned for the electronic device 100 or the housings 101 and 102 and, regardless of the relative positions (e.g., unfolded state or folded state) of the housings 101 and 102, the surface where the foldable display 103 of FIG. 1 is disposed may be defined as the front surface of the electronic device 100 (or housings 101 and 102), and the surface opposite to the surface where the foldable display 103 is disposed may be defined as the rear surface of the electronic device 100 (or housings 101 and 102).

Referring to FIGS. 1 and 2, the electronic device 100 includes a pair of housings 101 and 102, a foldable or flexible display 103, and a hinge module (e.g., the hinge module 204 of FIG. 3) that rotatably couple the housings 101 and 102. The electronic device 100 may further include a hinge cover(s) 199 disposed at the top and/or the bottom. The hinge cover(s) 199 may be disposed substantially between the first housing 101 and the second housing 102, and may be prevented from being visually exposed to the outside. In another embodiment, the hinge cover(s) 199 may isolate the internal space of the electronic device 100 from the external space. In some embodiments, the hinge cover(s) 199 may be visually exposed to the outside when the electronic device 100 is in the unfolded state, and may be visually concealed when the electronic device 100 is in the folded state.

According to an embodiment, as illustrated in FIG. 1, when the electronic device 100 (e.g., the first housing 101 and the second housing 102) is in the unfolded state, the flexible display 103 may output a screen through its entire area substantially in one direction, e.g., +Z direction. As illustrated in FIG. 2, when the electronic device 100 is in the folded state, a first display area A1 of the flexible display 103 may be disposed to face in the +Z direction, and a second display area A2 of the flexible display 103 may be disposed to face in the -Z direction. For example, the foldable display 103 may include areas (e.g., first display area A1 and second display area A2) disposed to face away from each other in the folded state of the electronic device 100. For example, the first housing 101 and the second housing 102 may rotate between a position in which they are stretched out side-by-side and a position in which they are folded to face each other. According to an embodiment, the foldable display 103 may include a folding area A3, and in the folded state of the electronic device 100, the folding area A3 may be disposed substantially in the +X direction. For example, in the state in which the first housing 101 and the second housing 102 are folded to face each other, the foldable display 103 may be visually exposed to the outside. According to the invention, the flexible display 103 is received in the first housing 101 and the second housing 102.

According to an embodiment, the first housing 101 and/or the second housing 102 may receive the foldable display 103 in the front surface and include rear plates 101b and 102b (e.g., the first rear plate 201b and second rear plate 202b of FIG. 3) disposed on the rear surface. The electronic device 100 may include a plurality of electric components, e.g., a circuit board, various sensor modules, a battery, an audio input/output module, a camera module, a haptic module, an antenna, and/or a connection terminal, disposed in the space between the foldable display 103 and the rear plates 101b and 102b. The first housing 101 may be coupled to the hinge module 204 to rotate about the first rotational axis P1. The second housing 102 may be coupled to the hinge module 204 to rotate about the second rotational axis P2. According to an embodiment, the first housing 101 and the second housing 102 may be disposed to be substantially symmetrical to each other with respect to the hinge module 204. According to an embodiment, when the first housing 101 rotates about the hinge module 204, the second housing 204 may rotate in the reverse direction of the first housing 101, allowing the electronic device to fold or unfold.

According to various embodiments, the foldable display 103 may include a first display area A1 disposed on a surface of the first housing 101, the folding area A3 disposed corresponding to the hinge module 204, and/or a second display area A2 disposed on one surface of the second housing 102. For example, the foldable display 103 may extend from one surface of the first housing 101 through the area where the hinge module 204 is disposed to one surface of the second housing 102. Substantially, the first display area A1 may be positioned on the first housing 101, and the second display area A2 may be positioned on the second housing 102. The folding area A3 may be supported by a multi-bar assembly (e.g., the multi-bar assembly 206 of FIG. 3). For example, the multi-bar assembly 206 may be disposed between the first housing 101 and the second housing 102 on the front surface of the electronic device 100, supporting the foldable display 103 (e.g., the folding area A3). According to an embodiment, the foldable display 103 may output a screen through substantially the entire area of the front surface of the electronic device 100.

According to various embodiments, when measured from a side surface of the first housing 101 through the position where of the hinge module 204 is disposed to a side surface of the second housing 102, along the X-axis direction in the unfolded state, the length (e.g., first length W1) of the front surface (e.g., the flexible display 103) of the electronic device 100, the length (e.g., first length w1) of the rear surface of the electronic device 100, and the length (e.g., second length w2) of the rear surface of the electronic device 100 may be substantially the same. When measured from a side surface of the first housing 101 through the position where of the hinge module 204 is disposed to a side surface of the second housing 102, along the X-axis direction in the folded state, the length (e.g., third length w3) of the front surface (e.g., the flexible display 103) of the electronic device 100 may be larger than the length (e.g., twice the fourth length w4) of the rear surface of the electronic device 100. Since the first display area A1 and the second display area A2 of the foldable display 103 are fixed to the first housing 101 and the second housing 102, and the width measured along the X direction is not substantially variable in the foldable display 103, the width measured along the X direction on the rear surface of the electronic device 100 may be varied. For example, a variation in the width measured along the X direction on the rear surface of the electronic device 100 may be implemented as a portion of the rear surface (e.g., the area indicated with `V1' and/or 'V2') of the electronic device 100 is contracted or expanded. According to another embodiment, the variation in the width measured along the X direction on the rear surface of the electronic device 100 may be implemented as the first housing 101 and/or the second housing 102 slides on the hinge module 204. According to another embodiment, as the first housing 101 and/or the second housing 102 slides on the hinge module 204, and the area indicated with `V1' and/or `V2' is contracted or expanded on the rear surface of the electronic device 100, corresponding to the slide of the first housing 101 and/or the second housing 102, the width measured along the X direction may be varied.

According to various embodiments, the change in the length of the rear surface of the electronic device 100 according to unfolding or folding may vary depending on the interval between the first rotational axis P1 and the second rotational axis P2. According to an embodiment, the variation in the length of the rear surface of the electronic device 100 according to the folding or unfolding may be proportional to the interval between the foldable display 103 and the rear surface of the electronic device 100. For example, as the thickness of the electronic device 100, measured in the Z direction increases, the variation in the length of the rear surface of the electronic device 100 according to folding or unfolding may increase.

According to an embodiment, the electronic device 100, e.g., the first housing 101 and/or the second housing 102, may include at least one sensor area S1 and S2 where at least one sensor module is provided. For example, the electronic device 100 may include a first sensor area S1 provided on the front surface or side surface of the first housing 101 and/or a second sensor area S2 provided on the front surface. For example, a fingerprint recognition sensor may be disposed in the first sensor area S1. The fingerprint recognition sensor may include, e.g., an optical fingerprint recognition sensor or an ultrasonic fingerprint recognition sensor and may be disposed on a side surface of the first housing 101 (or the second housing 102) or inside the foldable display 103. The electronic device 100 may include a sensor module provided in the second sensor area S2, e.g., a camera module, a proximity sensor, an illuminance sensor, an iris recognition sensor, an ultrasonic sensor, or an indicator. The sensor module(s) in the second sensor area S2 may be disposed inside the foldable display 103.

According to an embodiment, the electronic device 100 may include a notch portion protruding from the second sensor area S2 to the first display area A1 of the foldable display 103. The notch portion may be a structure forming the first housing 101 (or the second housing 102), and at least part of the sensor modules may be disposed in the notch portion. The notch portion may have a polygonal shape, a circular shape, or an elliptical shape. In another embodiment, in the second sensor area S2, the foldable display 103 may include a transparent area that permits external light to enter the inside. For example, among the sensor modules, an optical sensor, such as a camera module or a proximity sensor, may be disposed corresponding to the transparent area of the foldable display 103. According to an embodiment, the flexible display 103 may include a recess corresponding to the notch portion. For example, a portion (e.g., second sensor area S2) of the flexible display 103 corresponding to the notch portion may be removed.

According to an embodiment, the electronic device 100 (e.g., the sensor areas S1 and S2 or the sensor module) is not limited to the above-described configuration, and may include an additional sensor area or additional sensor module according to the function equipped in the electronic device 100 or the function of each sensor module. According to an embodiment, the electronic device 100 may not include some of the above-mentioned sensor modules.

According to an embodiment, the electronic device 100 may include a camera module 121 disposed on the rear surface (e.g., the rear surface of the second housing 102). According to an embodiment, the camera module may be interpreted as one of the sensor modules and may include a plurality of cameras, at least one infrared (IR) projector, at least one IR receiver, or a flash. The user may capture the object using the camera module 121 provided on the rear surface of the electronic device 100 (e.g., the second housing 102). According to an embodiment, the camera module 121 may be disposed in different positions, e.g., the position indicated with reference numeral '123a' or '123b' and the electronic device 100 may further include an additional camera module or sensor module in a position different from the position indicated in FIG. 1.

According to an embodiment, the electronic device 100 may include at least one key input device 111a and 111b disposed on a side surface of the first housing 101 (and/or the second housing 102). The key input devices 111a and 111b may include, e.g., a volume control key 111a and/or a power key 111b and, according to an embodiment, the key input devices 111a and 111b shown may be omitted, or an additional key input device may be provided. In some embodiments, the electronic device 100 may further include a soft key provided through the flexible display 103.

According to an embodiment, the electronic device 100 may include at least one connector hole 113a and 113b formed on a side surface of the electronic device 100 (e.g., a side, top, and/or bottom surface of the first housing 101 and/or the second housing 102). The connector holes 113a and 113b may include, e.g., a first connector hole 113a for charging/data cable connection and a second connector hole 113b for audio device (e.g., earphone) connection. According to an embodiment, the data cable may mean a cable provided to an audio device. For example, the electronic device 100 may not include the second connector hole 113b and connect to the audio device via the first connector hole 113a. According to an embodiment, the electronic device 100 may not include the connector holes 113a and 113b. For example, the electronic device 100 may connect to another electronic device 100 or an additional device, e.g., an earphone, wirelessly, by including a function, such as wireless charging, Bluetooth communication, wireless fidelity (Wi-Fi) direct, or infrared data association (IrDA).

According to an embodiment, the electronic device 100 may include a plurality of audio output holes 115a and 115b and a plurality of audio input holes 117a and 117b. In the illustrated embodiment, the audio output holes 115a and 115b may be formed on the top and bottom, respectively, of the first housing 101 (and/or the second housing 102). According to an embodiment, the audio output holes 115a and 115b may be formed on a side surface of the first housing 101 and an audio surface of the second housing 102, respectively. The audio input holes 117a and 117b may be formed on the top and bottom, respectively, of the electronic device 100, e.g., the first housing 101. The electronic device 100 may obtain the external audio through the plurality of audio input holes 117a and 117b, thereby performing such function as audio beam forming, active noise canceling (ANC), echo canceling (EC), noise suppression (NS), and/or feedforward (FF) in audio call or audio recording mode. According to an embodiment, an audio input hole not shown may further be formed in the rear surface of the first housing 101 (and/or the second housing 102). The electronic device 100 may obtain the external audio in capture mode, through the audio input hole formed in the rear surface of the first housing 101. As the number of audio input holes 117a and 117b and directions oriented are diversified, the electronic device 100 may provide better performance in audio beamforming, active noise canceling (ANC), echo canceling (EC), noise suppression (NS), and/or feed forward (FF).

According to an embodiment, in the unfolded position, the first housing 101 and the second housing 102 may be disposed to form a designated angle, e.g., 180 degrees, therebetween. When the electronic device 100 unfolds to the designated angle, the foldable display 103 may output a screen through substantially the entire area in the +Z direction. According to an embodiment, the first housing 101 and the second housing 102 may be unfolded obliquely between the position in which they are folded to face each other and the position of the designated angle. In the obliquely unfolded position, the first display area A1 and the second display area A2 of the flexible display 103 may output screens in different directions. For example, when unfolded obliquely, the electronic device 100 may provide screens to two users who sit facing each other. When the screen is output in the obliquely unfolded position, the screen output from the first display area A1 and the screen output from the second display area A2 may be the same as or different from each other.

According to an embodiment, in the folded state, the flexible display 103 may be substantially visually exposed to the outside. For example, the electronic device 100 may output a screen using the first display area A1, the second display area A2, and/or the folding area A3. In some embodiments, in the standby mode, the electronic device 100 may deactivate the screen of the flexible display 103 and activate a partial area according to a designated setting. For example, in the standby mode, the electronic device 100 may at least partially activate the first display area A1 to output daily information, such as time or weather. According to another embodiment, in the standby mode, the electronic device 100 may activate at least one of the first display area A1, the second display area A2, and/or the folding area A3 to provide visual information about the operation state or display notification information, such as messages or news.

According to an embodiment, the radius of curvature of the folding area A3 of the flexible display 103 may be varied when the electronic device 100 is folded or unfolded. For example, as the electronic device 100 is gradually unfolded from the folded state, the radius of curvature of the folding area A3 may gradually increase. In the folding or unfolding operation, the electronic device 100 may adjust a screen output through the folding area A3. For example, the electronic device 100 may compensate for distortion of the output screen according to the transformation of the folding area A3 by adjusting the horizontal-vertical ratio of the screen in the folding area A3 according to a change in the radius of curvature.

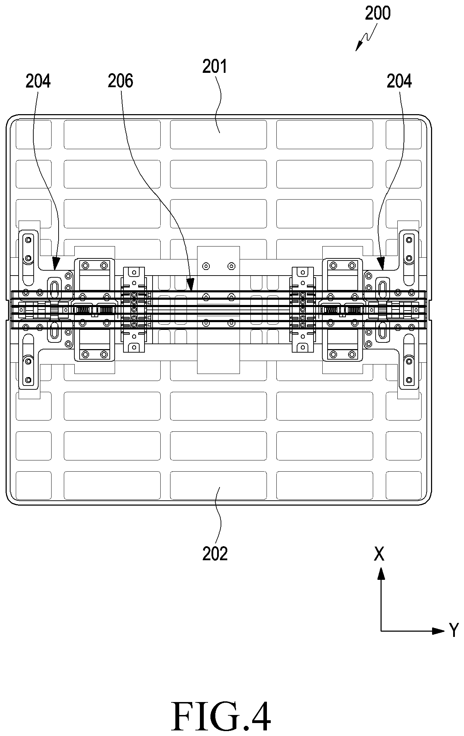

FIG. 3 is a perspective view illustrating an electronic device according to various embodiments of the invention. FIG. 4 is a view illustrating a connected structure of a first housing and a second housing in an electronic device according to various embodiments of the invention;

Referring to FIGS. 3 and 4, an electronic device 200 includes a first housing 201, a second housing 202 rotatably connected to the first housing 201, a hinge module 204 rotatably coupling the first housing 201 and the second housing 202, and a flexible display 203. The foldable display 203 may be disposed from one surface, e.g., the front surface, of the first housing 201 through the area in which the hinge module 204 is disposed to one surface (e.g., the front surface) of the second housing 202. The configuration of the first housing 201, the second housing 202, the hinge module 204, and the flexible display 203 of FIGS. 3 and 4 may be identical in whole or part to the configuration of the first housing 101, the second housing 102, and the flexible display 103 of FIGS. 1 and 2.

According to various embodiments, the flexible display 203 may include a display panel 231 and a display protective layer 233. The display panel 231 may include a light emitting layer formed between transparent substrates, and the transparent substrate may include an electric circuit, such as a touch sensor. For example, the display panel 231 may be formed of, e.g., organic light emitting diodes (OLEDs) or micro LEDs to output visual information, and may detect the user's direct contact to the display panel 231 or the user's motion within a certain distance. The display protective layer 233 may attach the display panel 231 to the first housing 201 and/or the second housing 202, be formed of an elastic material, and may be utilized as a cushioning material between the display panel 231 and the mechanical structure (e.g., the first housing 201 and/or the second housing 202).

According to various embodiments the flexible display 203 may include a first area A1 mounted or fixed to the first housing 201, a second area A2 positioned in the second housing 202, and a folding area A3 connecting the first area A1 and the second area A2. The folding area A3 may be disposed substantially corresponding to the area in which the hinge module 204 is disposed and may be transformed into a flat or curved shape as the electronic device 200 (e.g., the electronic device 100 of FIG. 1 and/or FIG. 2) folds or unfolds. When the electronic device 200 is in the unfolded position, the flexible display 203 may output a screen in one direction using substantially the entire area. When the electronic device 200 is in the folded position, the flexible display 203 may output screens in different directions using the first area A1 and the second area A2.

According to various embodiments, the first housing 201 may include a first housing member 201a and a first rear plate 201b coupled to the first housing member 201a. The second housing 202 may include a second housing member 202a and a second rear plate 202b coupled to the second housing member 202a. The first housing 201 and the second housing 202 may have substantially the same structure and may partially differ depending on the electric components disposed therein. For example, when the camera module 121 of FIG. 1 is disposed in one of the first housing 201 and the second housing 202, there may be a slight difference in the shape of the first housing 201 and the second housing 202 (e.g., the first rear plate 201b and the second rear plate 202b) or the structure of the first housing member 201a and the second housing member 202a. Such difference between the first housing 201 and the second housing 202 may be varied depending on the products actually manufactured.

According to various embodiments, the first housing member 201a may substantially form the outer appearance of the electronic device 200 (e.g., the first housing 201) and may include a first side bezel structure 211 and a first support plate 213. The first side bezel structure 211 may be a frame shape forming the side surface (e.g., the left side surface of FIG. 1), top and/or bottom of the first housing 201, and be open in the direction adjacent to the second housing 202. According to an embodiment, the first side bezel structure 211 may include a metal and/or polymer. For example, the first side bezel structure 211 may at least partially include a metal and/or an electrically conductive material, thereby serving as an antenna of the electronic device 200. According to an embodiment, the first side bezel structure 211 may include various coat layers, decorating the outer appearance of the electronic device 200 or providing an electrical insulation structure.

According to various embodiments, the first support plate 213 may be disposed in the space between the foldable display 203 and the first rear plate 201b and be connected with the first side bezel structure 211. According to an embodiment, the first support plate 213 may be integrally formed with the first side bezel structure 211 and may include the same material, e.g., metal and/or polymer, as the first side bezel structure 211. According to an embodiment, the first support plate 213 may include a metal and/or electrically conductive material, thereby providing an electromagnetically shielding structure inside the electronic device 200. According to an embodiment, the first support plate 213 may include a metal and/or electrically conductive material, functioning as a ground conductor that provides a reference potential inside the electronic device 200. According to an embodiment, the foldable display 103 (e.g., the first display area A1) may be positioned on the outer surface of the first support plate 213.

According to various embodiments, the first rear plate 201b may be formed by laminated or colored glass, ceramic, polymer, metal (e.g., aluminum, stainless steel (STS), or magnesium), or a combination of at least two thereof). In some embodiments, the first rear plate 201b may be formed substantially integrally with the first housing member 201a, e.g., the first side bezel structure 211. According to an embodiment, the first rear plate 201b may at least partially include a curved area. For example, an edge portion of the first rear plate 201b adjacent to the first side bezel structure 211 may include a portion that is bent towards the front surface (e.g., the surface where the foldable display 203 is disposed) of the electronic device 200 and seamlessly extended. In another embodiment, the first rear plate 201b may be disposed to be inclined with respect to the first display area A1 of the flexible display 103. For example, if the first rear plate 201b is located at a first height from the first display area A1 of the flexible display 103 at the edge adjacent to the second housing 202, it may be located at a second height lower than the first height at the end in the -X-axis direction.

According to various embodiments, the space between the first support plate 213 and the first rear plate 201b may be at least partially surrounded by the first side bezel structure 211. Although not shown, the electronic device 200 may receive various electric components, such as a printed circuit board, a battery, a haptic module, a camera module, a sensor module(s) and/or connection terminals, in the space between the first support plate 213 and the first rear plate 201b. For example, the first support plate 213 may be used as a structure that prevents other electric components of the electronic device 200 from contacting the flexible display 203. Some of the electric components received in the electronic device 200, e.g., a camera module (e.g., the camera module 121 of FIG. 1), may be partially exposed to an external space. Here, a component "exposed to the external space" may mean including a component that is isolated from the external space but is visually exposed and/or a component that is exposed to be directly contacted by the user. A processor, memory, and/or interface may be positioned on the printed circuit board.

The processor may include one or more of, e.g., a central processing unit, an application processor, a graphic processing device, a neural network processing device, an image signal processing, a sensor hub processor, or a communication processor. The battery may be a device for supplying power to at least one component of the electronic device 200. The battery 189 may include, e.g., a primary cell which is not rechargeable, a secondary cell which is rechargeable, or a fuel cell. At least a portion of the battery may be disposed substantially coplanar with the printed circuit board, for example between the first support plate 213 and the first rear plate 201b. The battery may be integrally or detachably disposed inside the electronic device 200.

According to various embodiments, an additional support plate and/or an antenna, not shown, may be provided in the space between the first support plate 213 and the first rear plate 201b. The additional support plate may enhance rigidity of the electronic device 200 and may provide an electromagnetic shielding structure between the electric components inside the electronic device 200. The antenna may be disposed between the first support plate 213 (and/or an additional support plate not shown) and the first rear plate 201b. The antenna may include, e.g., a near field communication (NFC) antenna, a wireless charging antenna, and/or a magnetic secure transmission (MST) antenna, performing short-range communication with an external device or wirelessly transmitting/receiving power required for charging. According to an embodiment of the present invention, an antenna structure may be formed by a portion or combination of the first side bezel structure 211 and/or the first support plate 213.

According to various embodiments, the second housing 202 may include a second housing member 202a (e.g., a second side bezel structure 221 and a second support plate 223) and a second rear plate 202b and, since it may have a similar structure to the structure of the first housing 201, a detailed description thereof will be omitted. In some embodiments, as mentioned above, since electrical components disposed in the first housing 201 and/or the second housing 202, e.g., the key input devices 111a and 111b of FIG. 1, the sensor areas S1 and S2, and/or the camera module 121, may be different from each other, the second housing 202 may be partially different in shape or structure from the first housing 201.

According to various embodiments, the hinge module 204 may rotatably couple the second housing 202 to the first housing 201. According to an embodiment, the first housing 201 may be coupled to the hinge module 204 to rotate about the first rotational axis P1. The second housing 202 may be coupled to the hinge module 204 to rotate about the second rotational axis P2. For example, the first housing 201 and the second housing 202 which are in the unfolded state may be rotated in reverse directions with respect to each other and folded. The first housing 201 and the second housing 202 which are in the folded state may be rotated in reverse directions with respect to each other and unfolded up to a designated angle. Here, the "designated angle" may mean 180 degrees.

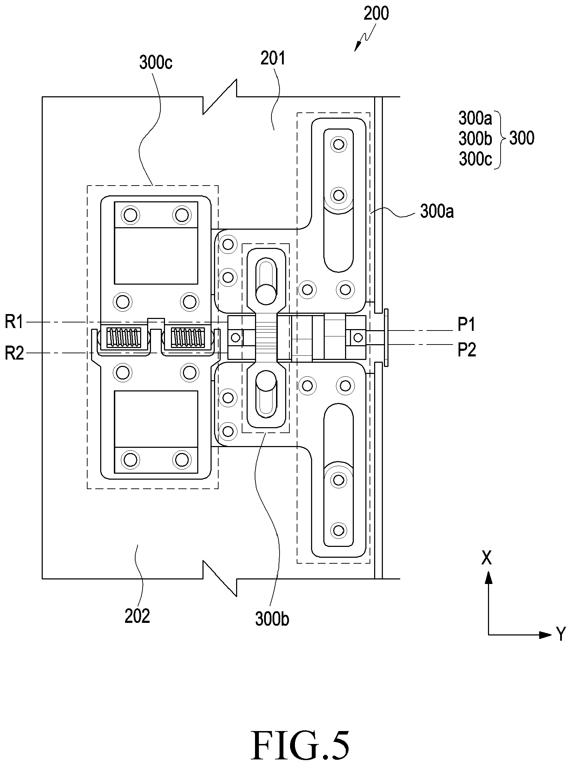

According to various embodiments, the second rotational axis P2 may be disposed in parallel with the first rotational axis P1 at the predetermined interval. In another embodiment, the second rotational axis P2 may be aligned with the first rotational axis P1. According to an embodiment, the hinge module 204 may allow the rotation of the second housing 202 to interlock with the rotation of the first housing 201. For example, when the first housing 201 rotates in a first direction (e.g., counterclockwise when viewed in the state illustrated in FIG. 3) around the first rotational axis P1, the hinge module 204 may rotate the second housing 202 in a second direction (e.g., clockwise when viewed in the state illustrated in FIG. 3) opposite to the first direction. According to an embodiment, the hinge module 204 may provide a friction force when the first housing 201 and/or the second housing 202 rotates. For example, when the user applies a certain degree of external force, the hinge module 204 may allow the first housing 201 and/or the second housing 202 to rotate, and if no external force is applied, the hinge module 204 may keep the first housing 201 and/or the second housing 202 stationary. In another embodiment, the hinge module 204 may keep the first housing 201 and/or the second housing 202 stationary in the position of the designated angle (e.g., the folded 0-degree position, the unfolded 180-degree position, and/or a position obliquely unfolded at about 120 degrees to about 160 degrees) or at the user's desired angle using a fixing portion (e.g., the first fixing portion 300c of FIG. 5).

According to various embodiments, the electronic device 200 may include a first slide plate 205a and a second slide plate 205b. The first slide plate 205a may be positioned on the first housing member 201a (e.g., the first support plate 213), and a portion of the hinge module 204 may be coupled to slide between the first support plate 213 and the first slide plate 205a. The second slide plate 205b may be positioned on the second housing member 201a (e.g., the second support plate 223), and a portion of the hinge module 204 may be coupled to slide between the second support plate 223 and the second slide plate 205b. For example, the first slide plate 205a and the second slide plate 205b may couple the first housing 201 and/or the second housing 202 to the hinge module 204 to guide or support the slide of the first housing 201 and/or the second housing 202. According to an embodiment, the first slide plate 205a and/or the second slide plate 205b may not be included in the electronic device 200.

According to various embodiments, the electronic device 200 may include a multi-bar assembly 206. The multi-bar assembly 206 may be disposed corresponding to the area in which the hinge module 204 is disposed and may be disposed between the first support plate 213 and the second support plate 323. For example, the multi-bar assembly 206 may be disposed to support the folding area A3 of the flexible display 203. According to an embodiment, the multi-bar assembly 206 may include multiple (e.g., five) bars or rods extending in one direction. The bars or rods of the multi-bar assembly 206 may have a circular, elliptical, or polygonal cross-section, and may be arranged in parallel with the length direction (Y-axis direction) of the electronic device 200, e.g., the first rotational axis P1 and/or the second rotational axis P2. According to an embodiment, the multiple bars or rods may be arranged along the width direction (X-axis direction) of the electronic device 200 to be rotatably connected with another adjacent bar or rod. As the bars or rods are rotated with respect to another adjacent bar or rod, the multi-bar assembly 206 may be transformed into a flat or curved shape. For example, when the electronic device 200 is folded or unfolded, the multi-bar assembly 206 may support the folding area 250 while transforming to correspond to the folding area 250 of the flexible display 203. When an external object or the user contacts the folding area 250 in the unfolded position of the electronic device 200, the multi-bar assembly 206 may support the folding area 250, suppressing the transformation of the folding area 250.

According to various embodiments, a plurality of (e.g., a pair of) hinge modules 204 may be provided and, when the hinge modules 204 are viewed along the length direction (e.g., Y-axis direction), the pair of hinge modules 204 may be aligned with each other. For example, the pair of hinge modules 204 may be symmetrical with respect to the width direction (e.g., the X-axis direction).

FIG. 5 is a view illustrating a structure in which a hinge module 300 is disposed in an electronic device according to various embodiments of the invention.

Referring to FIGS. 1 to 5, a hinge module 300 may include a rotating portion 300a, an interlocking portion 300b, and a first fixing portion 300c. The configuration of the hinge module 300 of FIG. 5 may be identical in whole or part to the configuration of the hinge module 300 of FIGS. 3 and 4.

According to various embodiments, the rotating portion 300a is a portion that substantially implements or guides the rotation of the first housing 201 and/or the second housing 202, and the first rotational axis P1 and/or the second rotational axis P2 may be configured by the structure of the rotating portion 300a.

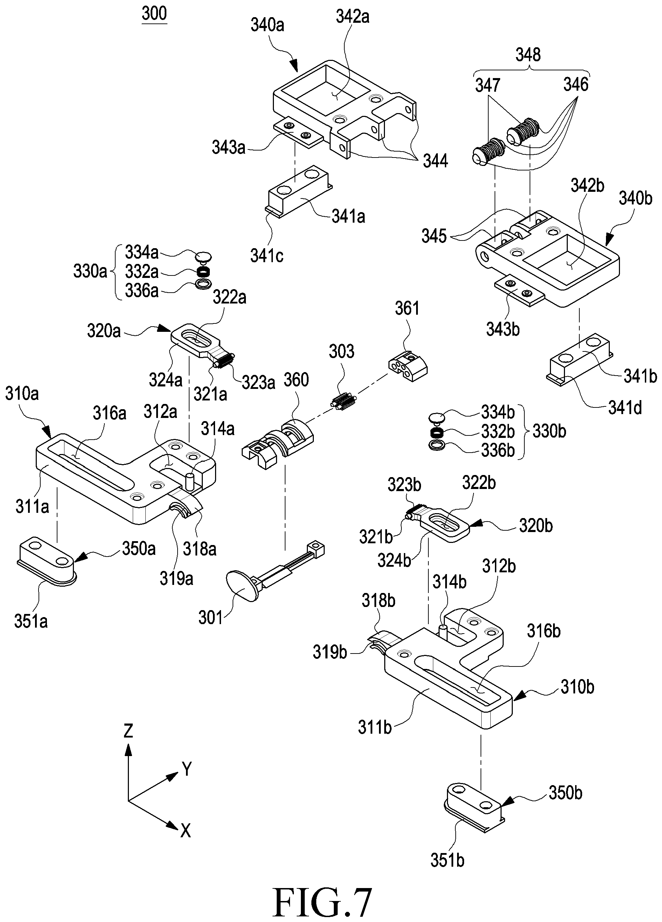

According to various embodiments, the interlocking portion 300b may allow the first housing 201 and the second housing 202 to interlock with each other using a structure in which a plurality of (e.g., a pair of or two pairs of) gears (e.g., the first gear 323a or second gear 323b of FIG. 7) are sequentially engaged. For example, among the gears of the interlocking portion 300b, the first gear 323a may be rotated as the first housing 201 rotates and, among the gears of the interlocking portion 300b, the second gear 323b may be rotated in a different direction (e.g., reverse direction) from the rotating direction (e.g., forward direction) of the first gear 323a as the second housing 202 rotates. For example, the first gear 323a and the second gear 323b may be spur gears, and may be engaged with each other to allow the rotation of the first housing 201 to interlock with the rotation of the second housing 202. In an embodiment, the rotational axis (e.g., first interlocking axis R1) of the first gear 323a may be disposed in parallel to the first rotational axis P1 and/or second rotational axis P2 in a position spaced apart from the rotational axis (e.g., second interlocking axis R2) of the second gear 323b.

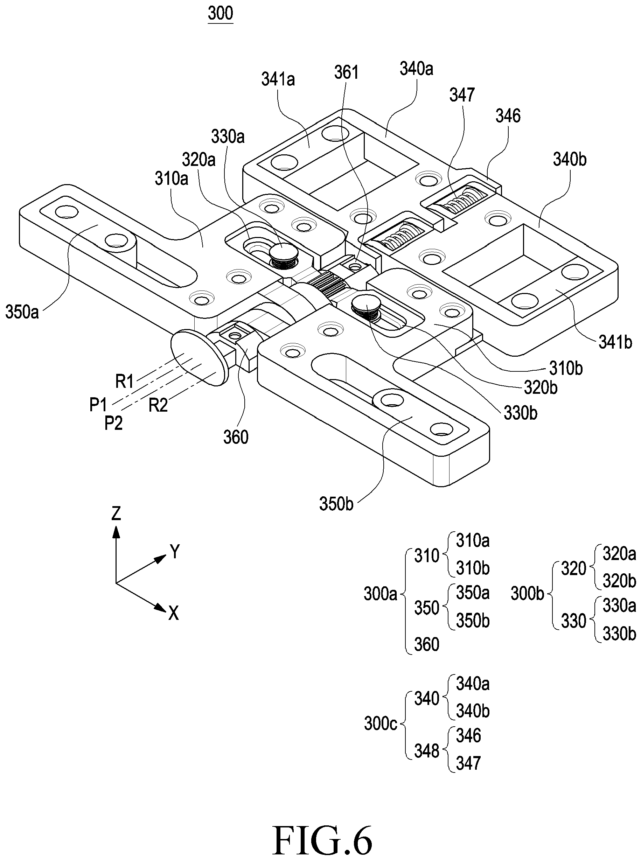

According to various embodiments, the first fixing portion 300c may include a structure (e.g., the fixing bracket 340a of FIG. 6) coupled with the first housing 201 and/or the second housing 202 and a structure (e.g., the stopper ball 346 or spring 347 of FIG. 7) for providing pressure to the structure coupled with the first housing 201 and/or second housing 202 and generate frictional force between the coupled structure and the structure for providing pressure. For example, when the user applies a predetermined degree of or more external force, the hinge module 300 may allow the first housing 201 and/or the second housing 202 to rotate, and if no external force is applied, the hinge module 300 may keep the first housing 201 and/or the second housing 202 stationary using the first fixing portion 300c.

According to various embodiments, the first fixing portion 300c, along with the rotating portion 300a, may implement or guide rotation of the first housing 201 and/or the second housing 202. For example, the first fixing portion 300c may include a structure (e.g., the third slide member 341a or fourth slide member 341b of FIG. 7) that may rotate together with the first housing 201 and/or the second housing 202.

According to various embodiments, the hinge module 300 may be positioned between the first support plate 213 and the first slide plate 205a and/or between the second support plate 223 and the second slide plate 205b. For example, the rotating portion 300a and first fixing portion 300c of the hinge module 300 may come in surface contact with the housing (e.g., the first housing 201 and/or the second housing 202).

In the following detailed description, the electronic device 100 of FIGS. 1 to 4 and/or the hinge module 300 of FIG. 5 may be referred to as necessary. In the following embodiments, the components identical to those in the above embodiments or easy to understand from the description of the above embodiments are denoted with or without the same reference numerals and their detailed description may be skipped.

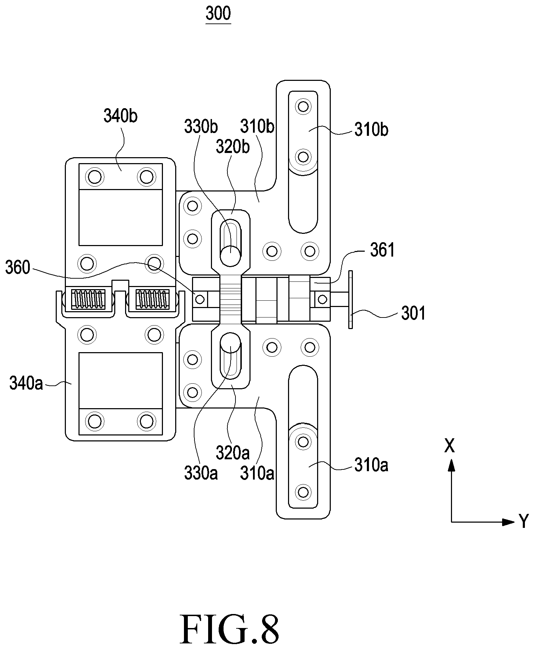

FIG. 6 is a perspective view illustrating a hinge module according to various embodiments of the invention. FIG. 7 is an exploded perspective view illustrating a hinge module according to various embodiments of the invention. FIG. 8 is a plan view illustrating a hinge module according to various embodiments of the invention.

Referring to FIGS. 6 to 8, a hinge module 300 may include a plurality of components constituting a rotating portion 300a, an interlocking portion 300b, and a first fixing portion 300c. The configuration of the hinge module 300 of FIGS. 6 to 8 may be identical in whole or part to the configuration of the hinge module 300 of FIG. 5.

According to various embodiments, the rotating portion 300a of the hinge module 300 may include a hinge bracket 360, a rotation bracket 310 configured to rotate (rotate and/or slide) about the hinge bracket 360, and a slide member 350 configured to slide in the rotation bracket 310.

According to various embodiments, the hinge module 300 may include a hinge cover 301. According to an embodiment, the hinge cover 301 may be coupled with the hinge bracket 360 and the gear box 361, reducing or preventing inflow of external foreign objects. The configuration of the hinge cover 301 may be identical in whole or part to the configuration of the hinge cover 199 of FIGS. 1 and 2.

According to the invention, the rotation bracket 310 includes a first rotation bracket 310a and a second rotation bracket 310b. According to the invention, the first rotation bracket 310a is mounted or coupled to be rotatable about the hinge bracket 360 and be connected to the first housing 201. The second rotation bracket 310b is mounted or coupled to be rotatable about the hinge bracket 360 and be connected with the second housing 202. The first rotation bracket 310a may include a first slide frame 311a coupled with the first housing (e.g., the first housing 201 of FIG. 5) and a first rotation arm 318a extending from the first slide frame 311a, and the second rotation bracket 310b may include a second slide frame 311b coupled with the second housing (e.g., the second housing 202 of FIG. 5) and a second rotation arm 318b extending from the second slide frame 311b. According to an embodiment, the first rotation arm 318a may rotate about the first rotational axis P1, and the second rotation arm 318b may rotate about the second rotational axis P2.

According to various embodiments, the first slide frame 311a may include a first guide hole 316a extending in the width direction (e.g., X-axis direction) of the electronic device (e.g., the electronic device 100 of FIG. 1) and passing through the first slide frame 311a in the thickness direction (e.g., Z-axis direction). The first slide member 350a may be slidably received in the first guide hole 316a. According to an embodiment, the first slide member 350a may be positioned substantially between the first housing 201, e.g., the first support plate 213 and second slide plate 205a of FIG. 3. According to an embodiment, the first guide hole 316a may be formed in a polygonal or closed loop shape, and the first slide member 350a may be constrained to be slidable in the width direction (e.g., X-axis direction) in the first guide hole 316a.

According to various embodiments, the first slide member 350a may include a first slide rib 351a. For example, the first slide member 350a may be coupled to come in line contact or surface contact with the first rotation bracket 310a through the first slide rib 351a to be coupled to be slidable about the first rotation bracket 310a.

According to various embodiments, the second slide member 350b may include a second slide rib 351b. For example, the second slide member 350b may be coupled to come in line contact or surface contact with the second rotation bracket 310b through the second slide rib 351b to be coupled to be slidable about the second rotation bracket 310b.

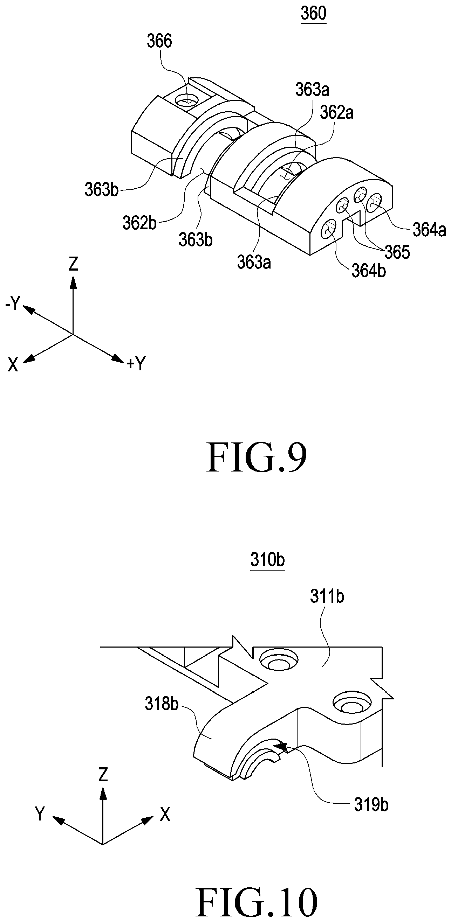

According to various embodiments, the first rotation arm 318a and the second rotation arm 318b may be rotatably coupled to the hinge bracket 360. For example, the first rotation arm 318a may be rotatably received in the first rotation space (e.g., the first rotation space 362a of FIG. 9) of the hinge bracket 360, and the second rotation arm 318b may be rotatably received in the second rotation space (e.g., the second rotation space 362b of FIG. 9) of the hinge bracket 360. The first rotation arm 318a and the second rotation arm 318b are described in detail with reference to FIG. 10.

According to various embodiments, the rotation bracket 310 may include a first receiving recess 312a and a second receiving recess 312b. According to an embodiment, the first rotation bracket 310a may include the first receiving recess 312a capable of receiving a portion of the first interlocking member 320a, and the second rotation bracket 310b may include a second receiving recess 312b capable of receiving a portion of the second interlocking member 320b. According to an embodiment, the first receiving recess 310a may be a recess that extends in the width direction (e.g., X-axis direction) of the electronic device (e.g., the electronic device 100 of FIG. 1) in the first slide frame 311a and is dug in the thickness direction (e.g., Z-axis direction). According to an embodiment, at least a portion of the first interlocking member 320a may be received in the first receiving recess 312a and be slid in the width direction (e.g., X-axis direction). According to an embodiment, the first rotation bracket 310a may slide in the width direction (e.g., X-axis direction) with respect to the first interlocking member 320a disposed in the first receiving recess 312a. According to an embodiment, the first receiving recess 312a may be opened in the direction (e.g., X-axis direction) towards the first rotational axis P1 to enable movement of the first interlocking member 320a and be closed in the direction (e.g., direction towards the first side bezel structure 211 or -X-axis direction of FIG. 3) opposite to the direction towards the first rotational axis P1 to restrict movement of the first interlocking member 320a. For example, the first receiving recess 312a may be a recess dug in the width direction (e.g., X-axis direction) from one surface of the first rotation bracket 310a facing the hinge bracket 360. According to various embodiments, the rotation bracket 310a and 310b may include a first coupling fastening portion 314a and a second fastening portion 314b. According to an embodiment, the first fastening portion 314a may protrude in the direction (e.g., Z-axis direction) from the first receiving recess 312a to the display (e.g., the display 103 of FIG. 1). According to an embodiment, the first fastening portion 314a may be positioned in the first through hole 322a of the first interlocking member 320a to guide movement of the first interlocking member 320a. For example, the first fastening portion 314a may restrict the moving distance of the first interlocking member 320a.

According to various embodiments, the second rotation bracket 310b may be a component symmetrical with the first rotation bracket 310a. The description of the first slide frame 311a of the first rotation bracket 310a, the first receiving recess 312a, the first fastening portion 314a, the first rotation arm 318a, and the first slide member 350a may be applied to the second slide frame 311b of the second rotation bracket 310b, the second receiving recess 312b, the second fastening portion 314b, the second rotation arm 318b, and the second slide member 350b.

According to various embodiments, the interlocking portion 300b of the hinge module 300 may include an interlocking member 320 and a guide member 330.

According to the invention, the interlocking member 320 includes a first interlocking member 320a and a second interlocking member 320b. The first interlocking member 320a may include a first interlocking member frame 324a and a first gear shaft 321a extending from the first interlocking member frame 324a, and the second interlocking member 320b may include a second interlocking member frame 324b and a second gear shaft 321b extending from the second interlocking member frame 324b. According to an embodiment, the first interlocking member 320a and the second interlocking member 320b may be rotatably coupled or mounted on the hinge bracket 360. For example, the first interlocking member 320a may be configured to slide with respect to the first rotation bracket 310a in the first receiving recess 312a, and the second interlocking member 320b may be configured to slide with respect to the second rotation bracket 310b in the second receiving recess 312b.

According to various embodiments, the first interlocking member 320a may include a first through hole 322a formed in the first interlocking member frame 324a, and the second interlocking member 320b may include a second through hole 322b formed in the second interlocking member frame 324b. According to an embodiment, the first interlocking member frame 324a may include the first through hole 322a passing through the first interlocking member frame 324a in the first direction (e.g., the thickness direction (Z-axis direction) of the electronic device 100). The first fastening portion 314a may be positioned or received in the first through hole 322a.

According to various embodiments, the hinge module 300 may include a gear box 361. The gear box 361 may include a plurality of holes for receiving a first gear shaft 321a, a second gear shaft 321b, and the shafts (not shown) of the idle gears. According to an embodiment, the gear box 361 may face the hinge bracket 360. According to an embodiment, the gear box 361 may be spaced apart from the hinge bracket 360 in the length direction (e.g., Y-axis direction), and at least a portion (e.g., the first gear shaft 321a, the second gear shaft 321b, and the plurality of idle gears 303) of the interlocking member 320a and 320b may be disposed between the gear box 361 and the hinge bracket 360.

According to various embodiments, the first interlocking member 320a may include the first gear shaft 321a rotatably mounted between the hinge bracket 360 and the gear box 361. According to an embodiment, the first gear shaft 321a may be disposed in parallel to the length direction (Y-axis direction), and one end of the first gear shaft 321a may be rotatably coupled to the hinge bracket 360, and the other end may be rotatably coupled to the gear box 361.

According to various embodiments, the hinge module 300 may include a first gear 323a coupled to the first gear shaft 321a and a second gear 323b coupled to the second gear shaft 321b. According to an embodiment, the first gear 323a and the second gear 323b may be spur gears. According to an embodiment, if the first gear shaft 321a and the second gear shaft 321b are mounted on the hinge bracket 360, the first gear 323a and the second gear 323b may be connected to each other. For example, if either the first gear shaft 321a and the second gear shaft 321b rotates in the forward direction (e.g., clockwise direction), the other may be rotated in the reverse direction (e.g., counterclockwise direction). According to an embodiment, the first gear shaft 321a may be rotated about the first interlocking axis R1, and the second gear shaft 321b may be rotated about the second interlocking axis R2.

According to various embodiments, the hinge module 300 may include idle gears 303 disposed between the first gear 323a and the second gear 323b. For example, the first gear 323a may be connected with the second gear 323b through a plurality of (e.g., a pair of or two pairs of) idle gears 303. The first gear 323a and the second gear 323b may be rendered to interlock by the idle gear 303 to rotate in the reverse directions with respect to each other. According to an embodiment, the idle gears 303 may be connected with the first gear 323a and the second gear 323b.

According to various embodiments, the second interlocking member 320b may be a component symmetrical with the first interlocking member 320a. The description of the first gear shaft 321a, the first through hole 322a, the first gear 323a, and the first interlocking member frame 324a may be applied to the second gear shaft 321b of the second interlocking member 320b, the second through hole 322b, the second gear 323b, and the second interlocking member 320b.

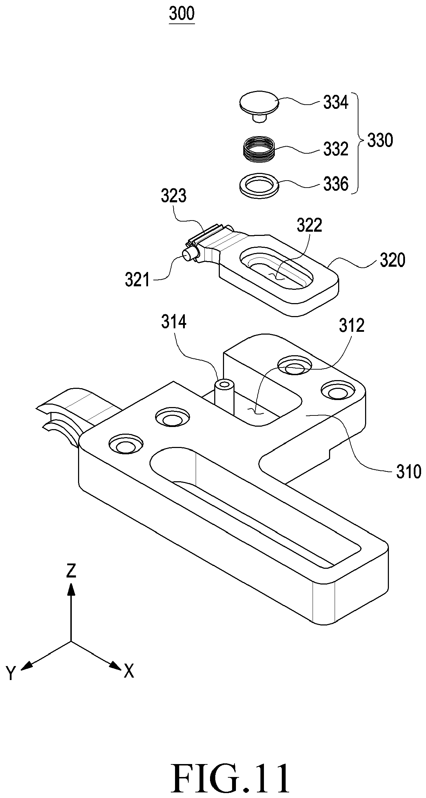

According to various embodiments, the guide member 330 may connect the interlocking member 320 with the rotation bracket 310. According to the invention, the guide member 330 includes a first guide member 330a and a second guide member 330b. The guide member 330 is described in detail with reference to FIG. 11.

According to various embodiments, the first fixing portion 300c of the hinge module 300 may include a fixing bracket (e.g., first fixing bracket 340a and second fixing bracket 340b) and a stopper structure 348.

According to various embodiments, the fixing bracket 340 may include a first fixing bracket 340a and a second fixing bracket 340b.

According to various embodiments, the fixing bracket 340 may be coupled with the rotation bracket 310. According to an embodiment, the first fixing bracket 340a may be coupled with the first rotation bracket 310a. For example, the first fixing bracket 340a may include a first connection portion 343a extending in the length direction (e.g., +Y-axis direction) of the hinge module 300, and the first connection portion 343a may be coupled with the first rotation bracket 310a. According to an embodiment, the second fixing bracket 340b may be coupled with the second rotation bracket 310b. For example, the second fixing bracket 340b may include a second connection portion 343b extending in the length direction (e.g., +Y-axis direction) of the hinge module 300, and the second connection portion 343b may be coupled with the second rotation bracket 310b.

According to various embodiments, the first fixing bracket 340a may include at least one interference plate 344 to receive the stopper structure 348 and/or a stopper structure receiving plate 345. According to an embodiment, the interference plate 344 may contact a plurality of stopper balls 346 positioned in the stopper structure receiving plate 345.

According to various embodiments, the second fixing bracket 340b may include the stopper structure receiving plate 345 to receive the stopper structure 348. A portion (e.g., stopper ball 346) of the stopper structure 348 may be visually exposed through the stopper structure receiving plate 345 and contact the interference plate 344. According to an embodiment, the stopper structure receiving plate 345 may be positioned between interference plates 344. For example, the stopper structure receiving plate 345 may be received in the interference plate 344.

According to various embodiments, the stopper structure 348 may include a plurality of stopper balls 346 and at least one spring 347. The spring 347 may be disposed between the stopper balls 346 to provide pressure or elastic force to the stopper balls 346 in the length direction (e.g., Y-axis direction) of the hinge module 300 or the electronic device (e.g., the electronic device 100 of FIG. 1). The hinge module 300 may be maintained at a preset angle or the user's desired angle using the resistance generated between the plurality of stopper balls 346 and the interference plate 344.

According to various embodiments, the first fixing bracket 340a may include a third guide hole 342a passing through the first fixing bracket 340a in the thickness direction (e.g., Z-axis direction) of the electronic device (e.g., the electronic device 100 of FIG. 1). The third slide member 341a may be slidably received in the third guide hole 342a. According to an embodiment, the third guide hole 342a may be formed in a polygonal or closed loop shape, and the third slide member 341a may be constrained to be slidable in the width direction (e.g., X-axis direction) of the electronic device 100 in the third guide hole 342a.

According to various embodiments, the third slide member 341a may include a third slide rib 341c. For example, the third slide member 341a may be coupled to come in line contact or surface contact with the first fixing bracket 340a through the third slide rib 341c to be coupled to be slidable about the first fixing bracket 340a.

According to various embodiments, the second fixing bracket 340b may include a fourth guide hole 342b passing through the second fixing bracket 340b in the thickness direction (e.g., Z-axis direction) of the electronic device (e.g., the electronic device 100 of FIG. 1). The fourth slide member 341b may be slidably received in the fourth guide hole 342b. According to an embodiment, the fourth guide hole 342b may be formed in a polygonal or closed loop shape, and the fourth slide member 341b may be constrained to be slidable in the width direction (e.g., X-axis direction) of the electronic device 100 in the fourth guide hole 342b.

According to various embodiments, the fourth slide member 341b may include a fourth slide rib 341d. For example, the fourth slide member 341b may be coupled to come in line contact or surface contact with the second fixing bracket 340b through the fourth slide rib 341d to be coupled to be slidable about the second fixing bracket 340b.

FIG. 9 is a perspective view illustrating a hinge bracket according to various embodiments of the invention. FIG. 10 is a perspective view illustrating a portion of a second rotation bracket 310b according to various embodiments of the invention.

Referring to FIG. 9, the hinge bracket 360 may provide a first rotation space 362a and a second rotation space 362b separated from each other. According to an embodiment, the first rotation space 362a may be a space in which the first rotation bracket 310a is rotatably received or positioned, and the second rotation space 311b may be a space in which the second rotation bracket 310b is rotatably received or positioned.

According to an embodiment, the hinge bracket 360 may include at least one first rotation rail 363a extending to form a curved trajectory. In the illustrated embodiment, a pair of first rotation rails 363a may protrude from the inner wall of the first rotation space 362a in a length direction, e.g., in the -Y direction and/or +Y direction. When projected and viewed along the Y-axis direction, the pair of first rotation rails 363a may be aligned with each other. According to an embodiment (not shown), when projected and viewed along the Y-axis direction, the pair of first rotation rails 363a may have different radii of curvature which are co-centered. According to an embodiment, the second rotation space 362b may be positioned in the -Y direction with respect to the first rotation space 362a on the hinge bracket 360. According to an embodiment, the first rotation rail 363a may guide rotation of the first rotation bracket 310a.

According to an embodiment, the hinge bracket 360 may include at least one second rotation rail 363b extending to form a curved trajectory. In the illustrated embodiment, a pair of second rotation rails 363b may protrude from the inner wall of the second rotation space 362b in a length direction, e.g., in the -Y direction and/or +Y direction. When projected and viewed along the Y-axis direction, the pair of second rotation rails 363b may be aligned with each other. According to an embodiment (not shown), when projected and viewed along the Y-axis direction, the pair of second rotation rails 363b may have different radii of curvature which are co-centered. According to an embodiment, the second rotation rail 363b may guide rotation of the second rotation bracket 310b.

According to an embodiment, the center of the curved trajectory formed by the first rotation rail 363a and/or the second rotation rail 363b, e.g., the center of the radius of curvature, may be located on the first rotational axis P1 and second rotational axis P2 of FIG. 3. For example, the positions of the first and second rotation axes P1 and P2 may be determined by the curved trajectory of the first rotation rail 363a and/or the second rotation rail 363b and the center of the radii of curvature of the first rotation rail 363a and/or the second rotation rail 363b. According to an embodiment, when projected and viewed along the length direction (e.g., Y-axis direction) of the hinge bracket 360, if the center of the radius of curvature of the first rotation rail 363a is aligned with the center of the radius of curvature of the second rotation rail 363b, the first rotational axis P1 and the second rotational axis P2 may be identical. In another embodiment, when projected and viewed along the Y-axis direction, if the positions of the centers of the radius of curvature of the first rotation rail 363a and the center of the radius of curvature of the second rotation rail 363b are different from each other, the second rotational axis P2 may be formed in a position spaced apart from the first rotational axis P1.

According to an embodiment, the hinge bracket 360 may include a first shaft hole 364a and a second shaft hole 364b. For example, in the end face of the hinge bracket 360 facing the inside (e.g., +Y direction) of the electronic device (e.g., the electronic device 100 of FIG. 1), the first shaft hole 364a and the second shaft hole 364b may be formed side by side. In an embodiment, the hinge bracket 360 may include a fastening hole 366 formed in the upper surface, e.g., the surface facing in the +Z direction. The fastening hole 366 may include, e.g., a thread formed on the inner wall, and may provide a means for positioning the hinge bracket 360 on the multi-bar assembly (e.g., the multi-bar assembly 206 of FIG. 3). According to an embodiment, the multi-bar assembly 206 may include a fastening boss corresponding to the fastening hole 366. According to an embodiment, the first shaft hole 364a may receive the first gear shaft 321a, and the second shaft hole 364b may receive the second gear shaft 321b.

According to various embodiments, the hinge bracket 360 may include a plurality of third shaft holes 365. The third shaft hole 365 may be formed in the end face of the hinge bracket 360 facing the inside (e.g., +Y direction) of the electronic device (e.g., the electronic device 100 of FIG. 1). According to an embodiment, the third shaft hole 365 may receive idle gears (e.g., the idle gears 303 of FIG. 7).

Referring to FIG. 10, the second rotation arm 318b may include at least one second rotation groove 319b that extends from an end of the second slide frame 311b and is formed in the surface facing in the -Y direction and/or the +Y direction.

According to various embodiments, the rotation groove 319b may have a shape and trajectory corresponding to the second rotation rail 363b. In an embodiment, the second rotation rail 363b may be received in the second rotation groove 319b to slide within the second rotation groove 319b. The second rotation bracket 310b may be coupled to the second rotation rail 363b of the hinge bracket 360 by the second rotation arm 318b and be guided by the second rotation groove 319b and the second rotation rail 363b to rotate about the hinge bracket 360.

According to various embodiments, the first rotation bracket 310a may be a component symmetrical with the second rotation bracket 310b, and the first rotation bracket 310a may include a first slide frame 311a, a first rotation arm 318a, and a first rotation groove (not shown). The description of the second slide frame 311b of the second rotation bracket 310b, the second rotation arm 318b, and the second rotation groove 319b may be applied to the first slide frame 311a of the first rotation bracket 310a, the first rotation arm 318a, and the first rotation groove (not shown).

FIG. 11 is a view illustrating a guide member positioned on a rotation bracket according to various embodiments of the invention.

Referring to FIG. 11 together with FIGS. 6 to 8, the guide member 330 may guide the movement of the interlocking member 320. For example, the guide member 330 may be connected or coupled with the rotation bracket 310, and the interlocking member 320 may rotate between the rotation bracket 310 and the guide member 330. The guide member 330 may prevent or reduce escape of the interlocking member 320 off the rotation bracket 310. According to an embodiment, the guide member 330 may connect the interlocking member 320 with the rotation bracket 310. The configuration of the hinge module 300, the rotation bracket 310, the interlocking member 320, and the guide member 330 of FIG. 11 may be identical or similar to the configuration of the hinge module 300, the rotation bracket 310, the interlocking member 320, and the guide member 330 of FIG. 6.

According to various embodiments, the guide member 330 may be positioned inside the through hole 322 of the interlocking member and the receiving recess 312 of the rotation bracket 310. For example, the first guide member 330a may be positioned inside the first through hole 322a of the first interlocking member 320a and over the first receiving recess 312a of the first rotation bracket 310a, and the second guide member 330b may be positioned inside the second through hole 322b of the second interlocking member 320b and over the second receiving recess 322b of the second rotation bracket 310b.

According to various embodiments, the guide member 330 may connect the rotation bracket 310 and the interlocking member 320. For example, the first guide member 330a may connect the first rotation bracket 310a with the first interlocking member 320a, and the second guide member 330b may connect the second rotation bracket 310b with the second interlocking member 320b. According to an embodiment, the first guide member 330a may be coupled with the first fastening portion 314a protruding from the first receiving recess 312a, and at least a portion (e.g., the first interlocking member frame 324a) of the first interlocking member 320a may be disposed between at least a portion (e.g., first pin 334a) of the first guide member 330a and the first rotation bracket 310a. According to an embodiment, the second guide member 330b may be coupled with the second fastening portion 324a protruding from the second receiving recess 312b, and at least a portion (e.g., the second interlocking member frame 324b) of the second interlocking member 320b may be disposed between at least a portion (e.g., second pin 334b) of the second guide member 330b and the second rotation bracket 310b.

According to various embodiments, the guide member 330 may absorb at least a portion of the vibration according to the movement of the interlocking member 320. For example, the guide member 330 may be used as a damping member. According to an embodiment, the guide member 330 may include an elastic member 332, a pin 334, and a washer 336. For example, the first guide member 330a may include a first elastic member 332a, a first pin 334a, and a first washer 336a, and the second guide member 330b may include a second elastic member 332b, a second pin 334b, and a second washer 336b.

According to various embodiments, the first pin 334a may be coupled with the first fastening portion 314a of the first rotation bracket 310a. According to the illustrated embodiment, the first fastening portion 314a may include a hole. The first pin 334a may be inserted into the hole of the first fastening portion 314a. As another example, the first pin 334a may include a hole (not shown). The first fastening portion 314a may be inserted into the hole of the first pin 334a.

According to various embodiments, the first elastic member 332a may provide an elastic force in the first direction (e.g., the thickness direction (Z-axis direction) of the hinge module 300). At least a portion of the vibration of the interlocking member (e.g., the first interlocking member 320a) of the hinge module 300 may be absorbed by the elastic force provided by the first elastic member 332a. For example, the first elastic member 332a may be used as a damping member for absorbing at least a portion of the vibration between the first pin 334a and the first interlocking member 320a. The first direction (Z-axis direction) may be a direction perpendicular to the surface (e.g., front surface) where the display (e.g., the display 103 of FIG. 1) is disposed or a surface of the display panel (e.g., the display panel 231 of FIG. 3). The first elastic member 332a may be disposed between the first pin 334a and the first interlocking member 320a. According to an embodiment, the first elastic member 332a may be a spring.

According to various embodiments, the first washer 336a may distribute the pressure between the first elastic member 332a and the first interlocking member 320a. According to an embodiment, the first washer 336a may be disposed between the first elastic member 332a and the first interlocking member 320a.

According to various embodiments, the guide member 330 may reduce damage to the interlocking member 320 sliding in the width direction (e.g., the X-axis direction) or unintended sound generation. For example, the electronic device (e.g., the electronic device 100 of FIG. 1) may rotate about the rotational axis (e.g., the first rotational axis P1 or the second rotational axis P2 of FIG. 6). The interlocking member 320 slid in the width direction (e.g., X-axis direction) when the electronic device 100 is rotated may be moved in the thickness direction (e.g., Z-axis direction) by the movement of the electronic device 100. The guide member 330 may absorb the force in the thickness direction (e.g., the Z-axis direction) and reduce the movement in the thickness direction of the interlocking member 320.

According to various embodiments, the second guide member 330b is a component symmetrical to the first guide member 330a. The description of the first pin 334a of the first guide member 330a, the first elastic member 332a, and the first washer 336a may be applied to the second pin 334b of the second guide member 330b, the second elastic member 332b, and the second washer 336b.

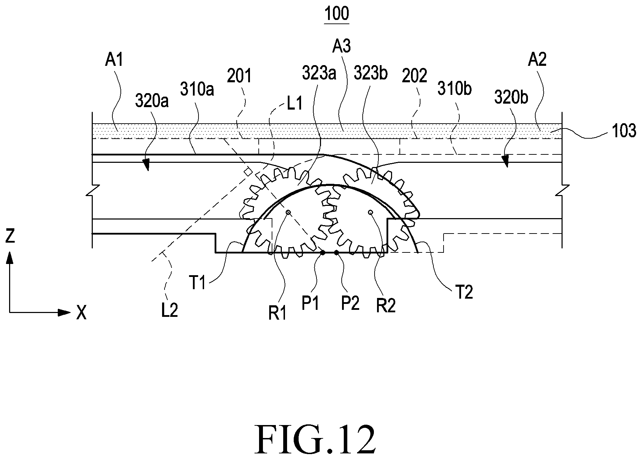

FIG. 12 is a view illustrating a positional relationship between rotation axes and/or interlocking axes of an electronic device and/or a hinge module.

Referring to FIG. 12, the first rotation bracket 310a and the second rotation bracket 310b may rotate substantially about the rotational axis (first rotational axis P1 or second rotational axis P2), and the interlocking member (first interlocking member 320a or second interlocking member 320b) may be slidably disposed on the first rotation bracket 310a or second rotation bracket 310b to rotate about the rotational axis (first interlocking axis R1 or second interlocking area R2) of the gear (first gear 323a or second gear 323b). According to an embodiment, as the first rotational axis P1 and the second rotational axis P2 become closer to each other, downsizing the electronic device may be easier. According to an embodiment, the first rotational axis P1 may be substantially the center of the radius of curvature of the first trajectory T1 provided by the first rotation rail (e.g., the first rotation rail 363a of FIG. 9), and the second rotational axis P2 may be substantially the center of the radius of curvature of the second trajectory T2 provided by the second rotation rail (e.g., the second rotation rail 363b of FIG. 9).

According to various embodiments, the spur gears (e.g., the first gear 323a and the second gear 323b) meshed with each other may allow the first housing 201 and the second housing 202 to interlock with each other. When the first gear 323a and the second gear 323b have an appropriate size in this interlocking structure, they may have sufficient mechanical strength. For example, the rotational axis P1 or P2 of the housings 201 and 202 may differ from the interlocking axis R1 or R2 of the gears 323a and 323b.

According to various embodiments, when the interlocking member 320a or 320b is rotated together with the gears 323a and 323b, the interlocking member 320a or 320b may remain substantially parallel to the rotation bracket 310a or 310b or the housing 201 or 202. In a state in which the rotational axis P1 or P2 of the rotation bracket 310a or 310b is not aligned with the interlocking axis R1 or R2 of the interlocking member 320a or 320b, the interval between the interlocking member 320a or 320b and a portion (e.g., the support plate 213 or 223 of FIG. 3) of the housing 201 or 202 may be changed while the interlocking member 320a or 320b is rotated and/or slid while remaining parallel to the housing 201 or 202. According to an embodiment, if the first support plate 213 is aligned (L2) perpendicular to the straight line L1 connecting the first rotational axis P1 and the first interlocking axis R1 (hereinafter, `vertically aligned position L2'), the interval between the first support plate 213 and the first interlocking member 320a in the thickness direction (e.g., Z-axis direction) may be minimized. For example, when rotated to the vertically aligned position L2 from the unfolded position of the housings 201 and 202, the interval between the interlocking member 320a or 320b and the support plate 213 or 223 may gradually decrease. According to another embodiment, when rotated from the vertically aligned position L2 to the folded position of the housings 201 and 202, the interval between the interlocking member 320a or 320b and the support plate 213 or 223 may gradually increase.

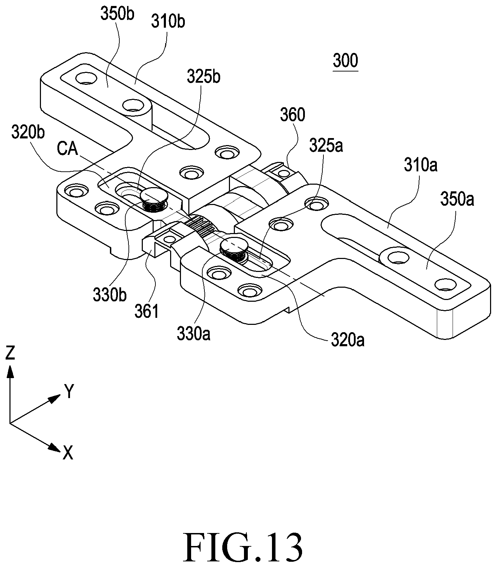

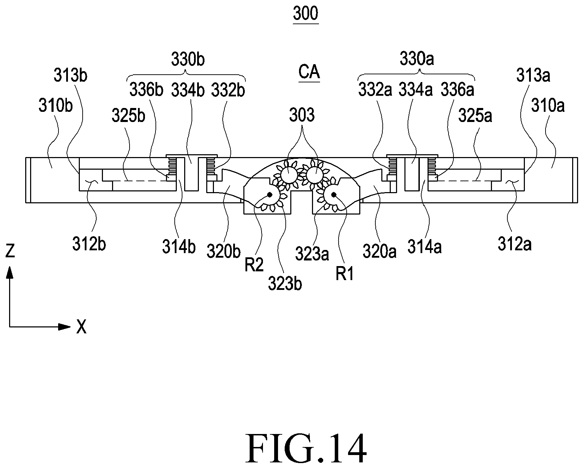

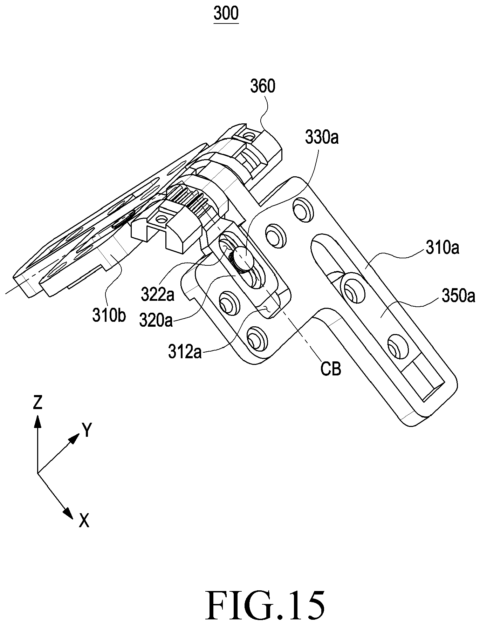

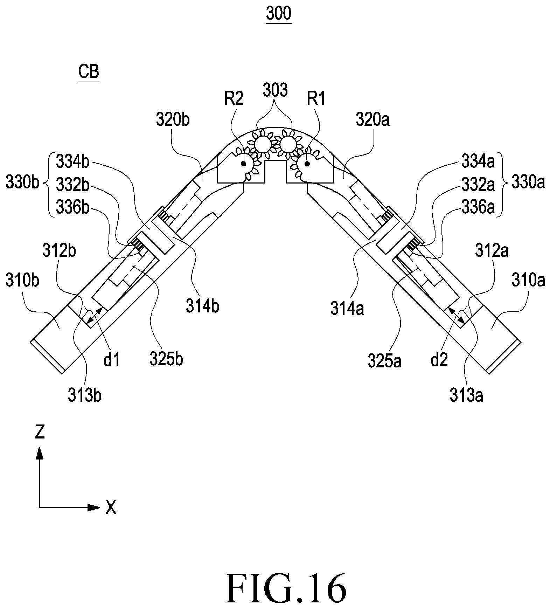

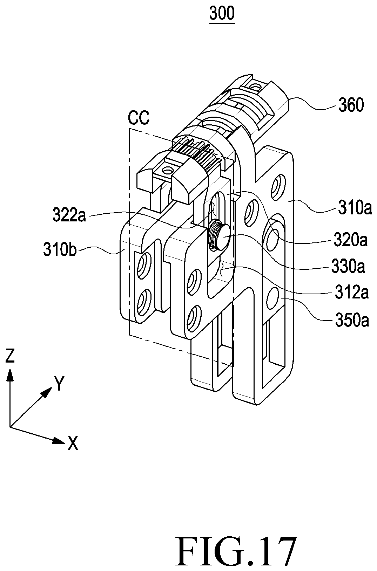

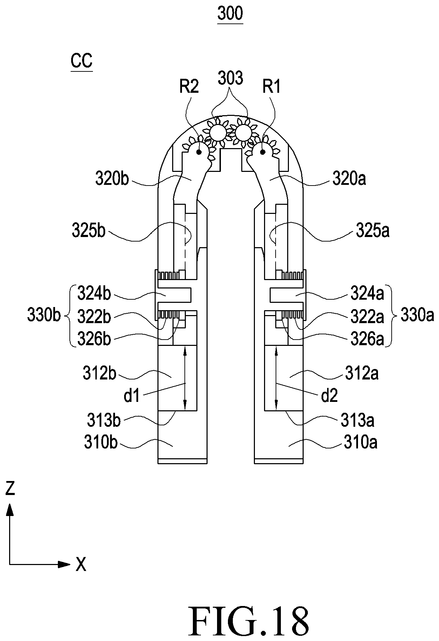

FIG. 13 is a perspective view illustrating an unfolded state of a hinge module according to various embodiments of the invention. FIG. 14 is a view taken along line 'CA' of FIG. 13. FIG. 15 is a perspective view illustrating an intermediate state of a hinge module according to various embodiments of the invention. FIG. 16 is a view taken along line 'CB' of FIG. 15. FIG. 17 is a perspective view illustrating a folded state of a hinge module according to various embodiments of the invention. FIG. 18 is a view taken along plane 'CC' of FIG. 17.

Referring to FIGS. 13 to 18 together with FIGS. 3 and 12, if the first housing 201 and the second housing 202 are rotated from the unfolded state (e.g., FIGS. 13 and 14) through the intermediate state (e.g., FIGS. 15 and 16) to the folded state (e.g., FIGS. 17 and 18) of the electronic device (e.g., the electronic device 200 of FIG. 3), the first housing 201 and/or the second housing 202 may be slid in the direction closer to the hinge module 300, e.g., the rotational axis P1 or P2.

According to various embodiments, when the first housing 201 and/or the second housing 202 is rotated, the slide member (first slide member 350a or second slide member 350b) may substantially slide on the rotation bracket (first rotation bracket 310a or second rotation bracket 310b) while guiding the slide of the first housing 201 and/or the second housing 202. The slide members 350a and 350b may move substantially linearly on the rotation brackets 310a and 310b. It has been discussed above that the length of the rear surface of the electronic device (e.g., the length measured in the X-axis direction of FIG. 1) may differ between the unfolded state and folded state of the electronic device (e.g., the electronic device 100 of FIG. 1). As the slide members 350a and 350b slide on the rotation brackets 310a and 310b, the length of the rear surface of the electronic device 100 may be changed. As the length of the rear surface of the electronic device 100 is changed, the exposure to the outside of a partial area, e.g., the area indicated with `V1' and/or `V2,' of the rear surface of the electronic device 100 may be decreased or increased as seen in Fig. 1.

According to various embodiments, when the first housing 201 and/or the second housing 202 is rotated, the interlocking member (first interlocking member 320a or second interlocking member 320b) may be slid with respect to the rotation bracket (e.g., first rotation bracket 310a or second rotation bracket 310b). For example, the interlocking members 320a and 320b may be engaged with each other using the gears (e.g., the first gear 323a, the second gear 323b, and/or the idle gears 303) and be rotated about the first interlocking axis R1 or the second interlocking axis R2. Since the rotation bracket 310a or 310b is rotated about the rotational axis (e.g., the first rotational axis P1 or second rotational axis P2 of FIG. 12) different from the interlocking axis R1 or R2, when the hinge module 300 and/or the electronic device 200 is rotated, the interlocking member 320a or 320b may be slid with respect to the rotation bracket 310a or 310b.

According to various embodiments, the distance (e.g., the first distance d1) between the inner surface 313a of the first rotation bracket 310a having the first receiving recess 312a and the first interlocking member 320a and the distance (e.g., the second distance d2) between the inner surface 313b of the second rotation bracket 310b having the second receiving recess 312b and the second interlocking member 320b may be changed depending on the angle of the electronic device 200 and/or the hinge module 300. According to an embodiment, in the unfolded state (e.g., FIGS. 13 and 14) of the electronic device 200 and/or the hinge module 300, the inner surface 313a of the first rotation bracket 310a may be brought in contact to the first interlocking member 320a, and the inner surface 313b of the second rotation bracket 310b may be brought in contact with the second interlocking member 320b. As another example, in the intermediate state (e.g., FIGS. 15 and 16) or unfolded state (e.g., FIGS. 17 and 18) of the electronic device 200 and/or the hinge module 300, the inner surface 313a of the first rotation bracket 310a and the first interlocking member 320a may be spaced apart from each other by the first distance d1, and the inner surface 313b of the second rotation bracket 310b and the second interlocking member 320b may be spaced apart from each other by the second distance d2. As the unfolded angle of the electronic device 200 and/or the hinge module 300 increases, the first distance d1 and the second distance d2 may increase. For example, the first distance d1 and second distance d2 of the hinge module 300 in the folded state (e.g., FIG. 17) may be larger than the first distance d1 and second distance d2 of the hinge module 300 in the intermediate state (e.g., FIG. 15). According to an embodiment, the first distance d1 and the second distance d2 may be substantially the same.

According to various embodiments, the interlocking member 320a or 320b may include an interlocking member rib (e.g., the first interlocking member rib 325a or the second interlocking member rib 325b). For example, the first interlocking member 320a may be coupled to come in line or surface contact with the first receiving recess 312a of the first rotation bracket 310a through the first interlocking member rib 325a to be coupled to be slidable about the first rotation bracket 310a. According to an embodiment, the interlocking member (first interlocking member 320a and/or second interlocking member 320b) may be in a direction (e.g., the second direction) perpendicular to the direction (e.g., the first direction) in which the guide member (first guide member 330a and/or second guide member 330b) provides pressure. For example, the guide member (first guide member 330a or second guide member 330b) may provide pressure in the direction perpendicular to the front or rear surface of the display (e.g., the flexible display 103 of FIG. 1), and the interlocking member (first interlocking member 320a and/or second interlocking member 320b) may slide in the direction parallel to the front or rear surface of the flexible display 103.

According to various embodiments, the interlocking member (first interlocking member 320a or second interlocking member 320b) may receive an elastic force by the guide member (first guide member 330a or second guide member 330b). For example, the washer (e.g., first washer 336a or second washer 336b) receiving pressure by the elastic member (e.g., first elastic member 332a or second elastic member 332b) may provide pressure to the interlocking member rib 325a or 325b. The interlocking member 320a or 320b may receive pressure by the guide member 330a or 330b and be thus prevented from escaping off the hinge module 300.

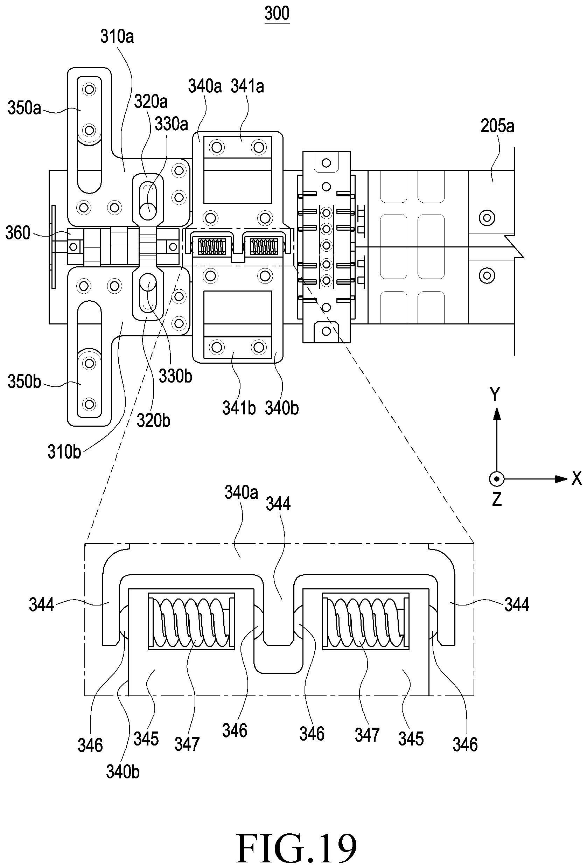

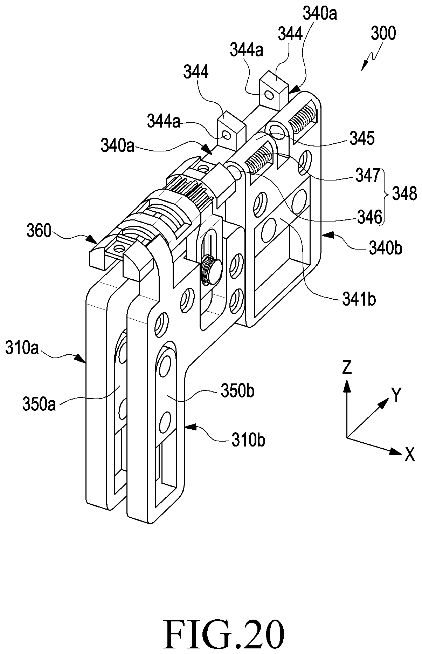

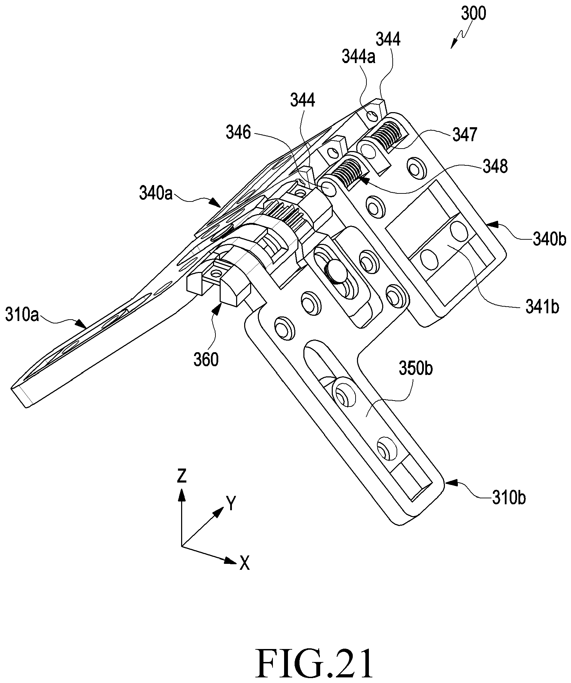

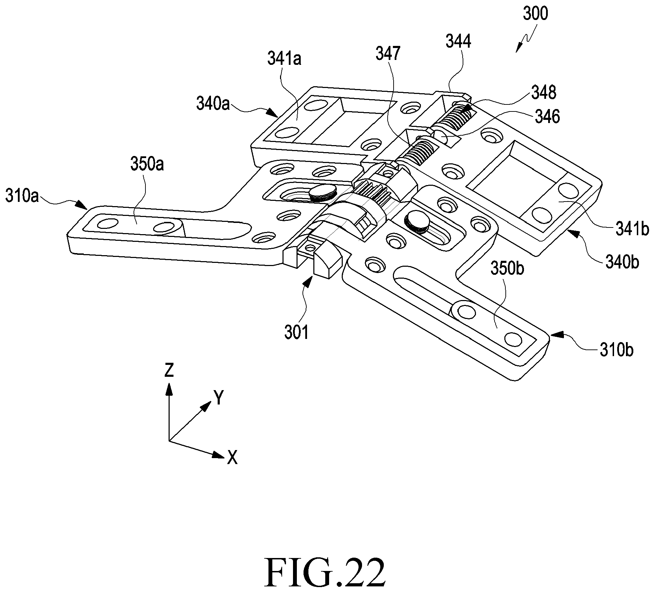

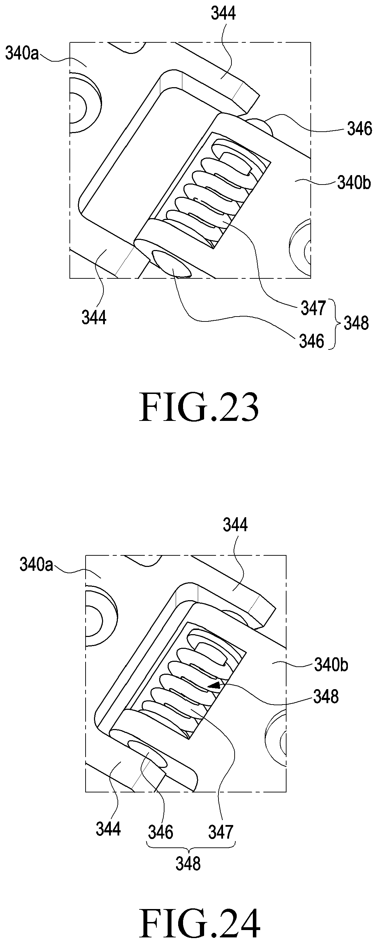

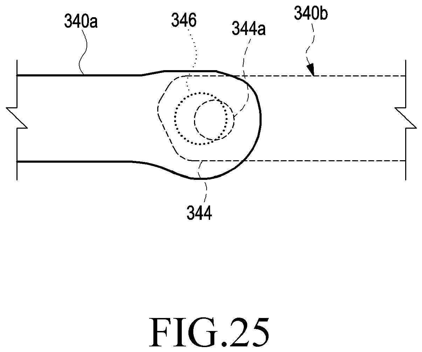

FIG. 19 is a view illustrating a hinge module including a stopper structure according to various embodiments of the invention. FIGS. 20, 21, and 22 are perspective views illustrating operations of a hinge module according to the angle of an electronic device according to various embodiments of the invention. FIGS. 23 and 24 are perspective views illustrating operations of a stopper structure according to the angle of an electronic device according to various embodiments of the invention. FIG. 25 is a view illustrating a stopper ball and a guide hole according to various embodiments of the invention.

Referring to FIGS. 19 to 25 together with FIG. 5, the hinge module 300 includes a rotation bracket 3 10a and 3 10b, an interlocking member 320a and 320b, a guide member 330a and 330b, and a fixing bracket 340a and 340b. The configuration of the rotation bracket 310a and 310b, the interlocking member 320a and 320b, the guide member 330a and 330b, and the fixing bracket 340a and 340b of FIGS. 19 to 25 may be identical in whole or part to the configuration of the rotation bracket 310a and 310b, the interlocking member 320a and 320b, the guide member 330a and 330b, and the fixing bracket 340a and 340b of FIGS. 6 and 7. The fixing bracket 340a and 340b may form a first fixing portion (e.g., the first fixing portion 300c of FIG. 5).

According to various embodiments, the first fixing bracket 340a may be disposed on either the first housing 201 or the second housing 202 to rotate about the hinge bracket 360. The second fixing bracket 340b may be disposed on the other one of the first housing 201 and the second housing 202, where the first fixing bracket 340a is not disposed, and may be substantially symmetrically disposed with the first fixing bracket 340a with respect to the hinge bracket 360. According to an embodiment, the first fixing bracket 340a may be fixed to any one of the first rotation bracket 310a and the second rotation bracket 320b, and the second fixing bracket 340b may be fixed to the other one, where the first fixing bracket 340a is not fixed, of the first rotation bracket 310a and the second rotation bracket 320b. According to an embodiment, the first fixing bracket 340a may be positioned a predetermined interval apart from the second fixing bracket 340b in the folded state of the electronic device 200 and/or the hinge module 300 and may interfere with the second fixing bracket 340b in the unfolded state of the electronic device 200 and/or the hinge module 300.

According to various embodiments, the second fixing bracket 340b of the hinge module 300 may further include a stopper structure 348. In the structure further including the stopper structure 348, even in the unfolded state of the electronic device, the second fixing bracket 340b may not interfere with the first fixing bracket 340a.

According to various embodiments, the stopper structure 348 may include at least one stopper ball 346 and a spring 347 and be disposed in the second fixing bracket 340b. According to an embodiment, the stopper structure 348 may include a pair of stopper balls 346 and one spring 347 disposed between the stopper balls 346. The spring 347 may provide an elastic force in directions along which the stopper balls 346 get farther away from each other (e.g., Y-axis direction). In the illustrated embodiment, a configuration in which a pair of stopper structures 348 are disposed in the second fixing bracket 340b is exemplified, and the number of the stopper structures 348 may be diversified according to an embodiment.

According to various embodiments, the stopper structure 348 may be received in the spaced provided by the stopper structure receiving plate 345 protruding substantially from the second fixing bracket 340b, and a portion of the stopper balls 346 may project to the outside of the second fixing bracket 340b in the -Y direction and/or +Y direction. According to an embodiment, the stopper structure 348 may be positioned a predetermined interval apart from the first fixing bracket 340a in the folded state of the electronic device 200 and/or the hinge module 300 and may interfere with the first fixing bracket 340a in the unfolded state of the electronic device 200 and/or the hinge module 300. For example, the second fixing bracket 340b and/or the stopper structure 348 may restrict rotation of the first housing 201 and/or the second housing 202, unintended by the user, in the unfolded state of the electronic device 200 and/or the hinge module 300.

According to various embodiments, the first fixing bracket 340a may include at least one interference plate 344 corresponding to at least one of the stopper balls 346. For example, in the unfolded state of the electronic device 200, the stopper balls 346 may interfere with the interference plate(s) 344. In the structure in which a pair of stopper structures 348 are disposed adjacent to each other, the first fixing bracket 340a may include three interference plates 344 and, when the electronic device 200 is unfolded, the stopper balls 346 may be interfered with by any one of the interference plates 344. While interfered with by the interference plate 344, the stopper balls 346 may be placed further inside the second fixing bracket 340b than when not interfered with by the interference plate 344. For example, the elastic force provided from the spring 347 may bring the stopper balls 346 in tight contact with the interference plate 344, maintaining the unfolded state of the electronic device 200 and/or the hinge module 300. According to an embodiment, the electronic device 200 and/or the hinge module 300 may further include a stopper recess 344a formed in the interference plate 344. For example, in the unfolded state of the electronic device 200, the stopper balls 346 are at least partially fitted into the stopper recess 344a, keeping the electronic device 200 in the unfolded state.

According to various embodiments, the first fixing bracket 340a and/or the second fixing bracket 340b may be directly coupled to any one of the rotation brackets 310a and 310b. The electronic device 200 and/or the hinge module 300 may include other slide members (e.g., third slide member 341a or fourth slide member 341b) slidably coupled to the first fixing bracket 340a and/or the second fixing bracket 340b, similar to the slide member (e.g., the first slide member 350a or the second slide member 350b). The third slide member 341a may be slidably received in the first fixing bracket 340a while being disposed in the first housing 201 (e.g., between the first support plate 213 and the first slide plate 205a). The fourth slide member 341b may be slidably received in the second fixing bracket 340b while being disposed in the second housing 202 (e.g., between the second support plate 223 and the second slide plate 205b). For example, the hinge module 300 may include two pairs of the slide members 350a, 350b, 341a, and 341b and thus be more firmly coupled to the housings 201 and 202.

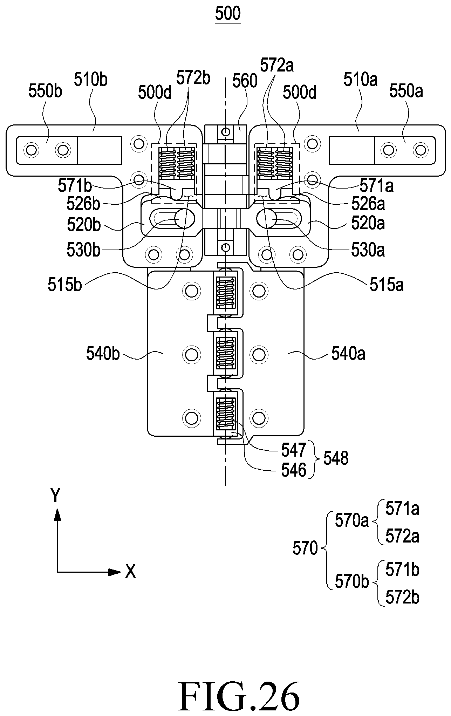

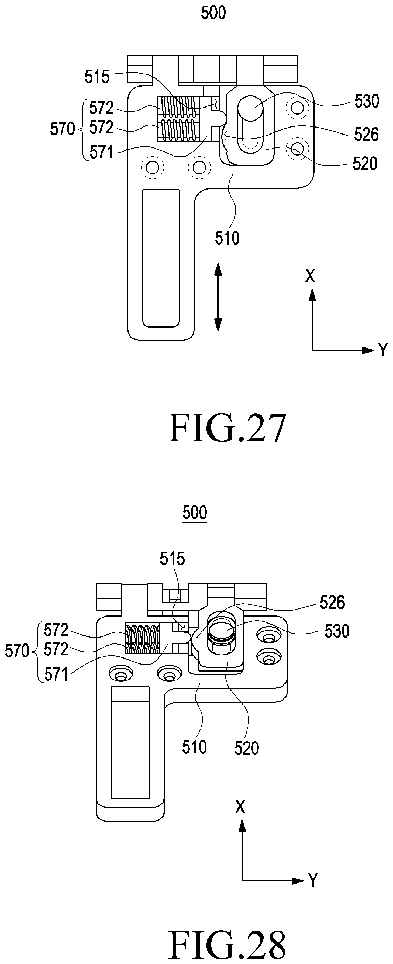

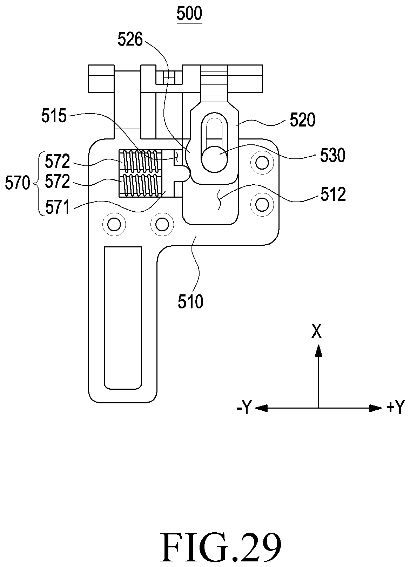

FIG. 26 is a plan view illustrating a hinge module including a second fixing portion according to various embodiments of the invention. FIG. 27 is a front view illustrating a stopper structure in an unfolded state according to various embodiments of the invention. FIG. 28 is a perspective view illustrating a stopper structure in an intermediate state according to various embodiments of the invention. FIG. 29 is a front view illustrating a stopper structure in a folded state according to various embodiments of the invention.

Referring to FIGS. 26 to 29 together with FIG. 6, a hinge module 500 may include a rotation bracket 510a and 510b, an interlocking member 520a and 520b, a guide member 530a and 530b, a fixing bracket 540a and 540b, and a hinge bracket 560. The configuration of the rotation bracket 510a and 510b of the hinge module 500, the interlocking member 520a and 520b, the guide member 530a and 530b, the fixing bracket 540a and 540b, the slide member 550a and 550b, and the hinge bracket 560 of FIGS. 26 to 29 may be identical in whole or part to the configuration of the rotation bracket 310a and 310b of the hinge module 300, the interlocking member 320a and 320b, the guide member 330a and 330b, the fixing bracket 340a and 340b, the slide member 350a and 350b, and the hinge bracket 360 of FIG. 6.

According to various embodiments, the hinge module 500 may keep the electronic device 200 and/or hinge module 500 stationary in the position of a designated angle (e.g., the folded 0-degree position, the unfolded 180-degree position, and/or a position obliquely unfolded at about 120 degrees to about 160 degrees) or at the user's desired angle using the second fixing portion 500d. According to an embodiment, the second fixed portion 500d may include a stopper structure 570 and a cam structure 526a and 526b of the interlocking member 520a and 520b described below.

According to various embodiments, the rotation bracket 510a and 510b may include a receiving recess (e.g., third receiving recess 515a or fourth receiving recess 515b) for receiving at least a portion (e.g., the second stopper structure 570a or third stopper structure 570b) of the second fixing portion 570d. For example, the first rotation bracket 510a may include a third receiving recess 515a for receiving the second stopper structure 570a, and the second rotation bracket 510b may include a fourth receiving recess 515b for receiving the third stopper structure 570b. According to an embodiment, the third receiving recess 515a may be formed integrally with the first receiving recess 512 (e.g., the first receiving recess 312a of FIG. 7). According to an embodiment, the fourth receiving recess 515b may be formed integrally with the second receiving recess 512 (e.g., the second receiving recess 312b of FIG. 7).

According to various embodiments, the hinge module 500 may include a stopper structure 570 (e.g., the second stopper structure 570a or the third stopper structure 570b). The elastic member 572 may provide an elastic force to the interlocking member 520 to maintain the electronic device 200 and/or the hinge module 500 at a predesignated angle or the user's desired angle. According to an embodiment, the stopper structure 570 may be disposed within the rotation bracket 510a and 510b. For example, the second stopper structure 570a may be disposed in the third receiving recess 515a of the first rotation bracket 510a, and the third stopper structure 570b may be disposed in the fourth receiving recess 515b of the second rotation bracket 520b.

According to various embodiments, the stopper structure 570 may include at least one elastic member 572 (e.g., the third elastic member 572a or the fourth elastic member 572b) that provides an elastic force to the interlocking member 520a and 520b. According to an embodiment, the elastic member 572 may provide an elastic force to the interlocking member 520 in the second direction (length direction (+Y direction)). The movement of the interlocking member 520 provided with the elastic force in the second direction (+Y direction) may be reduced or restricted in the width direction (e.g., the X-axis direction).

According to various embodiments, the stopper structure 570 may include a cam structure 571 (e.g., the first cam structure 571a or the second cam structure 571b). According to an embodiment, the cam structure 571 may contact the interlocking member 520. The cam structure 571 may transfer the elastic force transferred from the elastic member 572 to the interlocking member 520. For example, the first cam structure 571a may transfer the elastic force transferred from the third elastic member 572a to the first interlocking member 520a, and the second cam structure 571b may transfer the elastic force transferred from the fourth elastic member 572b to the second interlocking member 520b. According to an embodiment, the cam structure 571 may be disposed between the elastic member 572 and the interlocking member 520.

According to various embodiments, the interlocking member 520 (e.g., the first interlocking member 520a or the second interlocking member 520b) may include a cam structure 526 (e.g., third cam structure 526a or fourth cam structure 526b) protruding from the interlocking member frame (e.g., the first interlocking member frame 324a or second interlocking member frame 324b of FIG. 6) in the third direction (e.g., -Y direction) opposite to the second direction. For example, the first interlocking member 520a may include the third cam structure 526a protruding in the length direction (-Y direction) of the electronic device 200 and/or the hinge module 500, and the second interlocking member 520b may include the fourth cam structure 526b protruding in the length direction (-Y direction) of the electronic device and/or the hinge module 500. According to an embodiment, the cam structure 571 (e.g., the first cam structure 571a or the second cam structure 571b) of the stopper structure 570 may contact the cam structure 526 (e.g., the third cam structure 526a or the fourth cam structure 526b) of the interlocking member 520. By the contact between the cam structure 571 of the stopper structure 570 and the cam structure 526 of the interlocking member 520, the hinge module 300 may remain at a predetermined angle unless an external force unintended by the user is applied.

According to various embodiments, an electronic device (e.g., the electronic device 100 of FIG. 1) may comprise a first housing (e.g., the first housing 101 of FIG. 1), a second housing (e.g., the second housing 102 of FIG. 1), a display (e.g., the flexible display 103 of FIG. 1) received in the first housing and the second housing, and a hinge module (e.g., the hinge module 204 of FIG. 3) connecting the first housing and the second housing. The hinge module may include a hinge bracket (e.g., the hinge bracket 360 of FIG. 6), a first rotation bracket (e.g., the first rotation bracket 310a of FIG. 6) connected with the first housing and rotatably mounted on the hinge bracket, a second rotation bracket (e.g., the second rotation bracket 310b of FIG. 6) connected with the second housing and rotatably mounted on the hinge bracket, a first interlocking member (e.g., the first interlocking member 320a of FIG. 6) including a first gear shaft (e.g., the first gear shaft 321a of FIG. 7) having at least a portion received in the hinge bracket, and having at least a portion positioned on the first rotation bracket, a second interlocking member (e.g., the second interlocking member 320b of FIG. 6) including a second gear shaft (e.g., the second gear shaft 321b of FIG. 7) connected with the first gear shaft and having at least a portion received in the hinge bracket, and having at least a portion positioned on the second rotation bracket, a first guide member (e.g., the first guide member 330a of FIG. 6) connected with the first rotation bracket and configured to provide an elastic force to the first interlocking member in a first direction (e.g., the thickness direction (Z-axis direction) of FIG. 6) perpendicular to the display, and a second guide member (e.g., the second guide member 330b of FIG. 6) connected with the second rotation bracket and configured to provide an elastic force to the second interlocking member in the first direction.

According to various embodiments, the first rotation bracket may include a first receiving recess (e.g., the first receiving recess 312a of FIG. 7) for receiving a portion of the first interlocking member, and the second rotation bracket may include a second receiving recess (e.g., the second receiving recess 312b of FIG. 7) for receiving a portion of the second interlocking member. The first interlocking member may be configured to slide with respect to the first rotation bracket in the first receiving recess, and the second interlocking member may be configured to slide with respect to the second rotation bracket in the second receiving recess.

According to various embodiments, the first interlocking member may include a first interlocking member frame (e.g., the first interlocking member frame 324a of FIG. 7) including a first through hole (e.g., the first through hole 322a of FIG. 7) formed in the first direction, and the second interlocking member may include a second interlocking member frame (e.g., the second interlocking member frame 324b of FIG. 7) including a second through hole (e.g., the second through hole 322a of FIG. 7) formed in the first direction.

According to various embodiments, the first rotation bracket may include a first fastening portion (e.g., the first fastening portion 314a of FIG. 7) protruding towards the display and positioned in the first through hole, and the second rotation bracket may include a second fastening portion (e.g., the second fastening portion 314b of FIG. 7) protruding towards the display and positioned in the second through hole.

According to various embodiments, the first guide member may include a first pin (e.g., the first pin 334a of FIG. 7) coupled with the first rotation bracket and a first elastic member (e.g., the first elastic member 332a of FIG. 7) disposed between the first pin and the first interlocking member and configured to absorb at least a portion of vibration between the first pin and the first interlocking member, and the second guide member may include a second pin (e.g., the second pin 334b of FIG. 7) coupled with the second rotation bracket and a second elastic member disposed between the second pin and the second interlocking member and configured to absorb at least a portion of vibration between the second pin and the second interlocking member.

According to various embodiments, the first rotation bracket may include a first slide frame (e.g., the first slide frame 311a of FIG. 7) having a first guide hole (e.g., the first guide hole 316a of FIG. 7), and the second rotation bracket may include a second slide frame (e.g., the second slide frame 311b of FIG. 7) having a second guide hole (e.g., the second guide hole 316b of FIG. 7). The hinge module may include a first slide member (e.g., the first slide member 350a) configured to slide in the first guide hole and a second slide member (e.g., the second slide member 350b) configured to slide in the second guide hole.

According to various embodiments, the hinge bracket may include a first rotation rail (e.g., the first rotation rail 363a of FIG. 9) for guiding rotation of the first rotation bracket and a second rotation rail (e.g., the second rotation rail 363b of FIG. 9) for guiding rotation of the second rotation bracket.

According to various embodiments, the first rotation bracket may include a first rotation arm (e.g., the first rotation arm 318a of FIG. 7) having a first rotation groove receiving the first rotation rail, and the second rotation bracket may include a second rotation arm (e.g., the second rotation arm 318b of FIG. 7) having a second rotation groove (e.g., the second rotation groove 319b of FIG. 10) receiving the second rotation rail.

According to various embodiments, the hinge bracket may include a first shaft hole (e.g., the first gear shaft hole 364a of FIG. 9) receiving the first gear shaft and a second shaft hole (e.g., the second gear shaft hole 364b of FIG. 9) receiving the second gear shaft.

According to various embodiments, the hinge module may include a first gear (e.g., the first gear 323a of FIG. 7) coupled with the first gear shaft, a second gear (e.g., the second gear 323b of FIG. 7) coupled with the second gear shaft, and a plurality of idle gears (e.g., the idle gears 303 of FIG. 7) connected with the first gear and the second gear.

According to various embodiments, the hinge module may include a first fixing bracket (e.g., the first fixing bracket 340a of FIG. 7) coupled with the first rotation bracket, a second fixing bracket (e.g., the second fixing bracket 340b of FIG. 7) coupled with the second rotation bracket, and a stopper structure (e.g., the stopper structure 348 of FIG. 7) including a plurality of stopper balls (e.g., the stopper balls 346 of FIG. 7) and a spring (e.g., the spring 347 of FIG. 7) disposed between the plurality of stopper balls. The second fixing bracket may include a stopper structure receiving plate (e.g., the stopper structure receiving plate 345 of FIG. 7) receiving the stopper structure, and the first fixing bracket may include an interference plate (e.g., the interference plate 344 of FIG. 7) receiving the stopper structure receiving plate.

According to various embodiments, the first fixing bracket may include a third guide hole (e.g., the third guide hole 342a of FIG. 7) formed in the first direction and a third slide member (e.g., the third slide member 341a of FIG. 7) configured to slide in the third guide hole, and the second fixing bracket may include a fourth guide hole (e.g., the fourth guide hole 342b of FIG. 7) formed in the first direction and a fourth slide member (e.g., the fourth slide member 341b of FIG. 7) configured to slide in the fourth guide hole.

According to various embodiments, the hinge module may include a second stopper structure (e.g., the second stopper structure 570a of FIG. 26) including at least one third elastic member (e.g., the third elastic member 572a of FIG. 26) disposed in a third receiving recess (e.g., the third receiving recess 515a of FIG. 26) of the first rotation bracket and configured to provide an elastic force to the first interlocking member in a second direction (e.g., +Y direction of FIG. 26) perpendicular to the first direction and a first cam structure (e.g., the first cam structure 571a of FIG. 26) contacting the first interlocking member, and a third stopper structure (e.g., the third stopper structure 570b of FIG. 26) including at least one fourth elastic member (e.g., the fourth elastic member 572b of FIG. 26) disposed in a fourth receiving recess (e.g., the fourth receiving recess 515b of FIG. 26) of the second rotation bracket and providing an elastic force to the second interlocking member in the second direction and a second cam structure (e.g., the second cam structure 571b of FIG. 26) contacting the second interlocking member.

According to various embodiments, the first interlocking member may include a third cam structure (e.g., the third cam structure 526a of FIG. 26) protruding in a third direction (e.g., -Y direction of FIG. 26) opposite to the second direction and configured to contact the first cam structure, and the second interlocking member may include a fourth cam structure (e.g., the fourth cam structure 526b of FIG. 26) protruding in the third direction and configured to contact the second cam structure.

According to various embodiments, an electronic device (e.g., the electronic device 100 of FIG. 1) may comprise a first housing (e.g., the first housing 101 of FIG. 1), a second housing (e.g., the second housing 102 of FIG. 1), a display (e.g., the flexible display 103 of FIG. 1) received in the first housing and the second housing, and a hinge module (e.g., the hinge module 204 of FIG. 3) connecting the first housing and the second housing. The hinge module may include a hinge bracket (e.g., the hinge bracket 360 of FIG. 6), a first rotation bracket (e.g., the first rotation bracket 310a of FIG. 6) connected with the first housing and rotatably mounted on the hinge bracket, a second rotation bracket (e.g., the second rotation bracket 310b of FIG. 6) connected with the second housing and rotatably mounted on the hinge bracket, a first interlocking member (e.g., the first interlocking member 320a of FIG. 6) received in the first rotation bracket and rotatably mounted on the hinge bracket, a second interlocking member (e.g., the second interlocking member 320b of FIG. 6) received in the second rotation bracket and rotatably mounted on the hinge bracket, a first guide member (e.g., the first guide member 330a of FIG. 6) coupled with the first rotation bracket and configured to provide an elastic force to the first interlocking member in a first direction (e.g., Z-axis direction of FIG. 6) perpendicular to the display, and a second guide member (e.g., the second guide member 330b of FIG. 6) coupled with the second rotation bracket and configured to provide an elastic force to the second interlocking member in the first direction. The first interlocking member and the second interlocking member may be configured to slide in a second direction (e.g., the X-axis direction of FIG. 6) perpendicular to the first direction of the electronic device.

### [Legend of symbols (sequence list free text)]

100, 200: electronic device, 101, 201: first housing, 102, 202: second housing, 204, 300, 400, 500: hinge module, 310, 510: rotation bracket, 320, 520: interlocking member, 330, 530: guide member, 340, 540: fixing bracket

## Claims

1. An electronic device (100, 200), comprising:
a first housing (101, 201);
a second housing (102, 202);
a flexible display (103, 203) received in the first housing (101, 201) and the second housing (102, 202); and
a hinge module (204, 300, 400, 500) connecting the first housing (101, 201) and the second housing (102, 202), wherein the hinge module (204, 300, 400, 500) includes:
a hinge bracket (360, 560);
a first rotation bracket (310a, 510a) connected with the first housing (101, 201) and rotatably mounted on the hinge bracket (360, 560);
a second rotation bracket (310b, 510b) connected with the second housing (102, 202) and rotatably mounted on the hinge bracket (360, 560);
a first interlocking member (320a, 520a), at least a portion of which positioned on the first rotation bracket (310a, 510a) and includes a first gear shaft (321a), at least a portion of which is received in the hinge bracket (360, 560); a second interlocking member (320b, 520b), at least a portion of which positioned on the second rotation bracket (310b, 510b) and includes a second gear shaft (321b) connected with the first gear shaft (321a) and having at least a portion received in the hinge bracket (360, 560);
a first guide member (330a, 530a) connected with the first rotation bracket (310a, 510a) and configured to provide an elastic force to the first interlocking member (320a, 520a) in a first direction (Z) perpendicular to the flexible display (103, 203); and
a second guide member (330b, 530b) connected with the second rotation bracket (310b, 510b) and configured to provide an elastic force to the second interlocking member (320b, 520b) in the first direction (Z).

2. The electronic device (100, 200) of claim 1, wherein the first rotation bracket (310a, 510a) includes a first receiving recess (312a) configured to receive a portion of the first interlocking member (320a, 520a), and the second rotation bracket (310b, 510b) includes a second receiving recess (312b) configured to receive a portion of the second interlocking member (320b, 520b), and wherein the first interlocking member (320a, 520a) is configured to slide with respect to the first rotation bracket (310a, 510a) in the first receiving recess (312a), and the second interlocking member (320b, 520b) is configured to slide with respect to the second rotation bracket (310b, 510b) in the second receiving recess (312b).

3. The electronic device (100, 200) of any one of the preceding claims, wherein the first interlocking member (320a, 520a) includes a first interlocking member frame (324a) including a first through hole (322a) formed in the first direction (Z), and the second interlocking member (320b, 520b) includes a second interlocking member frame (324b) including a second through hole (322b) formed in the first direction (Z).

4. The electronic device (100, 200) of claim 3, wherein the first rotation bracket (310a, 510a) includes a first fastening portion (314a) protruding towards the flexible display (103, 203) and positioned in the first through hole (322a), and the second rotation bracket (310b, 510b) includes a second fastening portion (314b) protruding towards the flexible display (103, 203) and positioned in the second through hole (322b).

5. The electronic device (100, 200) of any one of the preceding claims, wherein the first guide member (330a, 530a) includes a first pin (334a) coupled with the first rotation bracket (310a, 510a) and a first elastic member (332a) disposed between the first pin (334a) and the first interlocking member (320a, 520a) and configured to absorb at least a portion of vibration between the first pin (334a) and the first interlocking member (320a, 520a), and the second guide member (330b, 530b) includes a second pin (334b) coupled with the second rotation bracket (310b, 510b) and a second elastic member (332b) disposed between the second pin (334b) and the second interlocking member (320b, 520b) and configured to absorb at least a portion of vibration between the second pin (334b) and the second interlocking member (320b, 520b).

6. The electronic device (100, 200) of any one of the preceding claims, wherein the first rotation bracket (310a, 510a) includes a first slide frame (311a) having a first guide hole (316a), and the second rotation bracket (310b, 510b) includes a second slide frame (311b) having a second guide hole (316b), and wherein the hinge module (204, 300, 400, 500) includes a first slide member (350a) configured to slide in the first guide hole (316a) and a second slide member (350b) configured to slide in the second guide hole (316b).

7. The electronic device (100, 200) of any one of the preceding claims, wherein the hinge bracket (360, 560) includes a first rotation rail (363a) configured to guide rotation of the first rotation bracket (310a, 510a) and a second rotation rail (363b) configured to guide rotation of the second rotation bracket (310b, 510b).

8. The electronic device (100, 200) of claim 7, wherein the first rotation bracket (310a, 510a) includes a first rotation arm (318a) having a first rotation groove receiving the first rotation rail (363a), and the second rotation bracket (310b, 510b) includes a second rotation arm (318b) having a second rotation groove receiving the second rotation rail (363b).

9. The electronic device (100, 200) of any one of the preceding claims, wherein the hinge bracket (360, 560) includes a first shaft hole (364a) receiving the first gear shaft (321a) and a second shaft hole (364b) receiving the second gear shaft (321b).

10. The electronic device (100, 200) of any one of the preceding claims, wherein the hinge module (204, 300, 400, 500) includes a first gear (323a) coupled with the first gear shaft (321a), a second gear (323b) coupled with the second gear shaft (321b), and a plurality of idle gears (303) connected with the first gear (323a) and the second gear (323b).

11. The electronic device (100, 200) of claim 10, wherein the hinge module (204, 300, 400, 500) includes a gear box (361) facing the hinge bracket (360, 560), and wherein the first gear shaft (321a), the second gear shaft (321b), and the plurality of idle gears (303) are disposed between the hinge bracket (360, 560) and the gear box (361).

12. The electronic device (100, 200) of any one of the preceding claims, wherein the hinge module (204, 300, 400, 500) includes:
a first fixing bracket (340a, 540a) coupled with the first rotation bracket (310a, 510a);
a second fixing bracket (340b, 540b) coupled with the second rotation bracket (310b, 510b); and
a stopper structure (348) including a plurality of stopper balls (346) and a spring disposed between the plurality of stopper balls (346), and wherein the second fixing bracket (340b, 540b) includes a stopper structure receiving plate (345) receiving the stopper structure (348), and the first fixing bracket (340a, 540a) includes an interference plate (344) receiving the stopper structure receiving plate (345).

13. The electronic device (100, 200) of claim 12, wherein the first fixing bracket (340a, 540a) includes a third guide hole (342a) formed in the first direction (Z) and a third slide member (341a) configured to slide in the third guide hole (342a), and the second fixing bracket (340b, 540b) includes a fourth guide hole (342b) formed in the first direction (Z) and a fourth slide member (341b) configured to slide in the fourth guide hole (342b).

14. The electronic device (100, 200) of any one of the preceding claims, wherein the hinge module (500) includes:
a second stopper structure (570a) including at least one third elastic member (572a) disposed in a third receiving recess (515a) of the first rotation bracket (510a) and configured to provide an elastic force to the first interlocking member (520a) in a second direction (Y) perpendicular to the first direction (Z) and a first cam structure (571a) contacting the first interlocking member (520a); and
a third stopper structure (570b) including at least one fourth elastic member (572b) disposed in a fourth receiving recess (515b) of the second rotation bracket (510b) and providing an elastic force to the second interlocking member (520b) in the second direction (Y) and a second cam structure (571b) contacting the second interlocking member (520b).

15. The electronic device (100, 200) of claim 14, wherein the first interlocking member (520a) includes a third cam structure (526a) protruding in a third direction (-Y) opposite to the second direction (Y) and configured to contact the first cam structure (571a), and the second interlocking member (520b) includes a fourth cam structure (526b) protruding in the third direction (-Y) and configured to contact the second cam structure (571b).

## Patentansprüche

1. Elektronische Vorrichtung (100, 200), umfassend:
ein erstes Gehäuse (101, 201);
ein zweites Gehäuse (102, 202);
eine flexible Anzeige (101, 203), die in dem ersten Gehäuse (101, 201) und dem zweiten Gehäuse (102, 202) angeordnet ist;
ein Scharniermodul (204, 300, 400, 500), das das erste Gehäuse (101, 201) und das zweite Gehäuse (102, 202) verbindet, wobei das Scharniermodul (204, 300, 400, 500) Folgendes umfasst:
einen Scharnierbügel (360, 560);
einen ersten Drehbügel (310a, 510a), der mit dem ersten Gehäuse (101, 201) verbunden und drehbar auf dem Scharnierbügel (360, 560) angebracht ist;
einen zweiten Drehbügel (310b, 510b), der mit dem zweiten Gehäuse (102, 202) verbunden und drehbar auf dem Scharnierbügel (360, 560) angebracht ist;
ein erstes Verriegelungselement (320a, 520a), von dem mindestens ein Abschnitt auf dem ersten Drehbügel (310a, 510a) positioniert ist und eine erste Getriebewelle (321a) enthält, von der mindestens ein Abschnitt in dem Scharnierbügel (360, 560) aufgenommen ist; ein zweites Verriegelungselement (320b, 520b), von dem mindestens ein Abschnitt auf dem zweiten Drehbügel (310b, 510b) positioniert ist und eine zweite Getriebewelle (321b) enthält, die mit der ersten Getriebewelle (321a) verbunden ist und mindestens einen Abschnitt aufweist, der im Scharnierbügel (360, 560) aufgenommen ist;
ein erstes Führungselement (330a, 530a), das mit dem ersten Drehbügel (310a, 510a) verbunden und konfiguriert ist, um eine elastische Kraft auf das erste Verriegelungselement (320a, 520a) in einer ersten Richtung (Z) senkrecht zu der flexiblen Anzeige (103, 203) auszuüben; und
ein zweites Führungselement (330b, 530b), das mit dem zweiten Drehbügel (310b, 510b) verbunden und konfiguriert ist, um eine elastische Kraft auf das zweite Verriegelungselement (320b, 520b) in der ersten Richtung (Z) auszuüben.

2. Elektronische Vorrichtung (100, 200) nach Anspruch 1, wobei der erste Drehbügel (310a, 510a) eine erste Aufnahmeausnehmung (312a) enthält, die konfiguriert ist, um einen Abschnitt des ersten Verriegelungselements (320a, 520a) aufzunehmen, und der zweite Drehbügel (310b, 510b) eine zweite Aufnahmeausnehmung (312b) enthält, die so konfiguriert ist, dass sie einen Abschnitt des zweiten Verriegelungselements (320b, 520b) aufnimmt, und wobei das erste Verriegelungselement (320a, 520a) so konfiguriert ist, dass es in Bezug auf den ersten Drehbügel (310a, 510a) in der ersten Aufnahmeausnehmung (312a) gleitet, und das zweite Verriegelungselement (320b, 520b) so konfiguriert ist, dass es in Bezug auf den zweiten Drehbügel (310b, 510b) in der zweiten Aufnahmeausnehmung (312b) gleitet.

3. Elektronische Vorrichtung (100, 200) nach einem der vorhergehenden Ansprüche, wobei das erste Verriegelungselement (320a, 520a) einen ersten Verriegelungselementrahmen (324a) enthält, der ein erstes Durchgangsloch (322a) aufweist, das in der ersten Richtung (Z) ausgebildet ist, und das zweite Verriegelungselement (320b, 520b) einen zweiten Verriegelungselementrahmen (324b) enthält, der ein zweites Durchgangsloch (322b) aufweist, das in der ersten Richtung (Z) ausgebildet ist.

4. Elektronische Vorrichtung (100, 200) nach Anspruch 3, wobei der erste Drehbügel (310a, 510a) einen ersten Befestigungsabschnitt (314a) enthält, der in Richtung der flexiblen Anzeige (103, 203) vorsteht und in dem ersten Durchgangsloch (322a) positioniert ist, und der zweite Drehbügel (310b, 510b) einen zweiten Befestigungsabschnitt (314b) enthält, der in Richtung der flexiblen Anzeige (103, 203) vorsteht und in dem zweiten Durchgangsloch (322b) positioniert ist.

5. Elektronische Vorrichtung (100, 200) nach einem der vorhergehenden Ansprüche, wobei das erste Führungselement (330a, 530a) einen ersten Stift (334a), der mit dem ersten Drehbügel (310a, 510a) gekoppelt ist, und ein erstes elastisches Element (332a), das zwischen dem ersten Stift (334a) und dem ersten Verriegelungselement (320a, 520a) angeordnet ist und so konfiguriert ist, dass es mindestens einen Abschnitt der Vibration zwischen dem ersten Stift (334a) und dem ersten Verriegelungselement (320a) absorbiert, enthält und das zweite Führungselement (330b, 530b) einen zweiten Stift (334b), der mit dem zweiten Drehbügel (310b, 510b) gekoppelt ist, und ein zweites elastisches Element (332b), das zwischen dem zweiten Stift (334b) und dem zweiten Verriegelungselement (320b, 520b) angeordnet und konfiguriert ist, um zumindest einen Abschnitt der Vibration zwischen dem zweiten Stift (334b) und dem zweiten Verriegelungselement (320b, 520b) zu absorbieren, enthält.

6. Elektronische Vorrichtung (100, 200) nach einem der vorhergehenden Ansprüche, wobei der erste Drehbügel (310a, 510a) einen ersten Gleitrahmen (311a) mit einem ersten Führungsloch (316a) enthält, und der zweite Drehbügel (310b, 510b) einen zweiten Gleitrahmen (311b) mit einem zweiten Führungsloch (316b) enthält, und wobei das Scharniermodul (204, 300, 400, 500) ein erstes Gleitelement (350a), das so konfiguriert ist, dass es in dem ersten Führungsloch (316a) gleitet, und ein zweites Gleitelement (350b) enthält, das so konfiguriert ist, dass es in dem zweiten Führungsloch (316b) gleitet.

7. Elektronische Vorrichtung (100, 200) nach einem der vorhergehenden Ansprüche, wobei der Scharnierbügel (360, 560) eine erste Drehschiene (363a) enthält, die so konfiguriert ist, dass sie die Drehung des ersten Drehbügels (310a, 510a) führt, und eine zweite Drehschiene (363b) enthält, die so konfiguriert ist, dass sie die Drehung des zweiten Drehbügels (310b, 510b) führt.

8. Elektronische Vorrichtung (100, 200) nach Anspruch 7, wobei der erste Drehbügel (310a, 510a) einen ersten Dreharm (318a) mit einer ersten Drehut zur Aufnahme der ersten Drehschiene (363a) enthält, und der zweite Drehbügel (310b, 510b) einen zweiten Dreharm (318b) mit einer zweiten Drehnut zur Aufnahme der zweiten Drehschiene (363b) enthält.

9. Elektronische Vorrichtung (100, 200) nach einem der vorhergehenden Ansprüche, wobei der Scharnierbügel (360, 560) ein erstes Wellenloch (364a) zur Aufnahme der ersten Getriebewelle (321a) und ein zweites Wellenloch (364b) zur Aufnahme der zweiten Getriebewelle (321b) enthält.

10. Elektronische Vorrichtung (100, 200) nach einem der vorhergehenden Ansprüche, wobei das Scharniermodul (204, 300, 400, 500) ein erstes Zahnrad (323a), das mit der ersten Getriebewelle (321a) gekoppelt ist, ein zweites Zahnrad (323b), das mit der zweiten Getriebewelle (321b) gekoppelt ist, und eine Vielzahl von Leerlaufzahnrädern (303), die mit dem ersten Zahnrad (323a) und dem zweiten Zahnrad (323b) verbunden sind, enthält.

11. Elektronische Vorrichtung (100, 200) nach Anspruch 10, wobei das Scharniermodul (204, 300, 400, 500) ein Getriebegehäuse (361) aufweist, das dem Scharnierbügel (360, 560) zugewandt ist, und wobei die erste Getriebewelle (321a), die zweite Getriebewelle (321b) und die Vielzahl von Leerlaufzahnrädern (303) zwischen dem Scharnierbügel (360, 560) und dem Getriebegehäuse (361) angeordnet sind.

12. Elektronische Vorrichtung (100, 200) nach einem der vorhergehenden Ansprüche, wobei das Scharniermodul (204, 300, 400, 500) Folgendes aufweist:
einen ersten Befestigungsbügel (340a, 540a), der mit dem ersten Drehbügel (310a, 510a) gekoppelt ist;
einen zweiten Befestigungsbügel (340b, 540b), der mit dem zweiten Drehbügel (310b, 5 10b) gekoppelt ist; und
eine Stopperstruktur (348), die eine Vielzahl von Stopperkugeln (346) und eine zwischen der Vielzahl von Stopperkugeln (346) angeordnete Feder aufweist, und wobei der zweite Befestigungsbügel (340b, 540b) eine Stopperstruktur-Aufnahmeplatte (345) aufweist, die die Stopperstruktur (348) aufnimmt, und der erste Befestigungsbügel (340a, 540a) eine Interferenzplatte (344) aufweist, die die Stopperstruktur-Aufnahmeplatte (345) aufweist.

13. Elektronische Vorrichtung (100, 200) nach Anspruch 12, wobei der erste Befestigungsbügel (340a, 540a) ein drittes Führungsloch (342a), das in der ersten Richtung (Z) ausgebildet ist, und ein drittes Gleitelement (341a) enthält, das so konfiguriert ist, dass es in dem dritten Führungsloch (342a) gleitet, und der zweite Befestigungsbügel (340b, 540b) ein viertes Führungsloch (342b), das in der ersten Richtung (Z) ausgebildet ist, und ein viertes Gleitelement (341b) enthält, das so konfiguriert ist, dass es in dem vierten Führungsloch (342b) gleitet.

14. Elektronische Vorrichtung (100, 200) nach einem der vorhergehenden Ansprüche, wobei das Scharniermodul (500) aufweist:
eine zweite Stopperstruktur (570a), die mindestens ein drittes elastisches Element (572a), das in einer dritten Aufnahmeausnehmung (515a) des ersten Drehbügels (510a) angeordnet und so konfiguriert ist, dass es eine elastische Kraft auf das erste Verriegelungselement (520a) in einer zweiten Richtung (Y) senkrecht zur ersten Richtung (Z) ausübt, und eine erste Nockenstruktur (571a), die mit dem ersten Verriegelungselement (520a) in Kontakt kommt, enthält; und
eine dritte Stopperstruktur (570b), die mindestens ein viertes elastisches Element (572b), das in einer vierten Aufnahmeausnehmung (515b) des zweiten Drehbügels (510b) angeordnet ist und eine elastische Kraft auf das zweite Verriegelungselement (520b) in der zweiten Richtung (Y) ausübt, und eine zweite Nockenstruktur (571b), die mit dem zweiten Verriegelungselement (520b) in Kontakt kommt, enthält.

15. Elektronische Vorrichtung (100, 200) nach Anspruch 14, wobei das erste Verriegelungselement (520a) eine dritte Nockenstruktur (526a), die in einer dritten Richtung (-Y) entgegengesetzt zur zweiten Richtung (Y) vorsteht und konfiguriert ist, um mit der ersten Nockenstruktur (571a) in Kontakt zu kommen, enthält, und das zweite Verriegelungselement (520b) eine vierte Nockenstruktur (526b), die in der dritten Richtung (-Y) vorsteht und konfiguriert ist, um mit der zweiten Nockenstruktur (571b) in Kontakt zu kommen, enthält.

## Revendications

1. Dispositif électronique (100, 200) comprenant :
un premier boîtier (101, 201) ;
un deuxième boîtier (102, 202) ;
un affichage flexible (103, 203) disposé dans le premier boîtier (101, 201) et le deuxième boîtier (102, 202) ;
un module de charnière (204, 300, 400, 500) reliant le premier boîtier (101, 201) et le deuxième boîtier (102, 202), dans lequel le module de charnière (204, 300, 400, 500) comprend :
un support de charnière (360, 560) ;
un premier support de rotation (310a, 510a) relié au premier boîtier (101, 201) et monté rotatif sur le support de charnière (360, 560) ;
un deuxième support de rotation (310b, 5 10b) relié au deuxième boîtier (102, 202) et monté rotatif sur le support de charnière (360, 560) ;
un premier élément de verrouillage (320a, 520a), dont au moins une partie est positionnée sur le premier support de rotation (310a, 510a) et comprend un premier arbre de transmission (321a), dont au moins une partie est reçue dans le support de charnière (360, 560) ; un deuxième élément de verrouillage (320b, 520b), dont au moins une partie est positionnée sur le deuxième support de rotation (310b, 510b) et comprend un deuxième arbre de transmission (321b) relié au premier arbre de transmission (321a) et dont au moins une partie est reçue dans le support de charnière (360, 560) ;
un premier élément de guidage (330a, 530a) relié au premier support de rotation (310a, 510a) et configuré pour fournir une force élastique au premier élément de verrouillage (320a, 520a) dans une première direction (Z) perpendiculaire à l'affichage flexible (103, 203) ; et
un deuxième élément de guidage (330b, 530b) relié au deuxième support de rotation (310b, 5 10b) et configuré pour fournir une force élastique au deuxième élément de verrouillage (320b, 520b) dans la première direction (Z).

2. Dispositif électronique (100, 200) de la revendication 1, dans lequel le premier support de rotation (310a, 510a) comprend un premier renfoncement de réception (312a) configuré pour recevoir une partie du premier élément de verrouillage (320a, 520a), et le deuxième support de rotation (310b, 510b) comprend un deuxième renfoncement de réception (312b) configuré pour recevoir une partie du deuxième élément de verrouillage (320b, 520b), et dans lequel le premier élément de verrouillage (320a, 520a) est configuré pour glisser par rapport au premier support de rotation (310a, 510a) dans le premier renfoncement de réception (312a), et le deuxième élément de verrouillage (320b, 520b) est configuré pour glisser par rapport au deuxième support de rotation (310b, 510b) dans le deuxième renfoncement de réception (312b).

3. Dispositif électronique (100, 200) de l'une quelconque des revendications précédentes, dans lequel le premier élément de verrouillage (320a, 520a) comprend un premier cadre d'élément de verrouillage (324a) comprenant un premier trou traversant (322a) formé dans la première direction (Z), et le deuxième élément de verrouillage (320b, 520b) comprend un deuxième cadre d'élément de verrouillage (324b) comprenant un deuxième trou traversant (322b) formé dans la première direction (Z).

4. Dispositif électronique (100, 200) de la revendication 3, dans lequel le premier support de rotation (310a, 510a) comprend une première partie de fixation (314a) faisant saillie vers l'affichage flexible (103, 203) et positionnée dans le premier trou traversant (322a), et le deuxième support de rotation (310b, 510b) comprend une deuxième partie de fixation (314b) faisant saillie vers l'affichage flexible (103, 203) et positionnée dans le deuxième trou traversant (322b).

5. Dispositif électronique (100, 200) de l'une quelconque des revendications précédentes, dans lequel le premier élément de guidage (330a, 530a) comprend une première broche (334a) couplée au premier support de rotation (310a, 510a) et un premier élément élastique (332a) disposé entre la première broche (334a) et le premier élément de verrouillage (320a, 520a) et configuré pour absorber au moins une partie des vibrations entre la première broche (334a) et le premier élément de verrouillage (320a, 520a), et le deuxième élément de guidage (330b, 530b) comprend un deuxième axe (334b) couplé au deuxième support de rotation (310b, 510b) et un deuxième élément élastique (332b) disposé entre le deuxième axe (334b) et le deuxième élément de verrouillage (320b, 520b) et configuré pour absorber au moins une partie des vibrations entre le deuxième axe (334b) et le deuxième élément de verrouillage (320b, 520b).

6. Dispositif électronique (100, 200) de l'une quelconque des revendications précédentes, dans lequel le premier support de rotation (310a, 510a) comprend un premier cadre coulissant (311a) ayant un premier trou de guidage (316a), et le deuxième support de rotation (310b, 510b) comprend un deuxième cadre coulissant (311b) ayant un deuxième trou de guidage (316b), et dans lequel le module de charnière (204, 300, 400, 500) comprend un premier élément coulissant (350a) configuré pour coulisser dans le premier trou de guidage (316a) et un deuxième élément coulissant (350b) configuré pour coulisser dans le deuxième trou de guidage (316b).

7. Dispositif électronique (100, 200) de l'une quelconque des revendications précédentes, dans lequel le support de charnière (360, 560) comprend un premier rail de rotation (363a) configuré pour guider la rotation du premier support de rotation (310a, 510a) et un deuxième rail de rotation (363b) configuré pour guider la rotation du deuxième support de rotation (310b, 510b).

8. Dispositif électronique (100, 200) de la revendication 7, dans lequel le premier support de rotation (310a, 510a) comprend un premier bras de rotation (318a) ayant une première rainure de rotation recevant le premier rail de rotation (363a), et le deuxième support de rotation (310b, 510b) comprend un deuxième bras de rotation (318b) ayant une deuxième rainure de rotation recevant le deuxième rail de rotation (363b).

9. Dispositif électronique (100, 200) de l'une des revendications précédentes, dans lequel le support de charnière (360, 560) comprend un premier trou d'arbre (364a) recevant le premier arbre de transmission (321a) et un deuxième trou d'arbre (364b) recevant le deuxième arbre de transmission (321b).

10. Dispositif électronique (100, 200) de l'une quelconque des revendications précédentes, dans lequel le module de charnière (204, 300, 400, 500) comprend un premier pignon (323a) couplé au premier arbre de transmission (321a), un deuxième pignon (323b) couplé au deuxième arbre de transmission (321b), et une pluralité de pignons libres (303) connectés au premier pignon (323a) et au deuxième pignon (323b).

11. Dispositif électronique (100, 200) de la revendication 10, dans lequel le module de charnière (204, 300, 400, 500) comprend une boîte de transmission (361) faisant face au support de charnière (360, 560), et dans lequel le premier arbre de transmission (321a), le deuxième arbre de transmission (321b), et la pluralité de pignons libres (303) sont disposés entre le support de charnière (360, 560) et la boîte de transmission (361).

12. Dispositif électronique (100, 200) de l'une quelconque des revendications précédentes, dans lequel le module de charnière (204, 300, 400, 500) comprend :
un premier support de fixation (340a, 540a) couplé au premier support de rotation (310a, 510a) ;
un deuxième support de fixation (340b, 540b) couplé au deuxième support de rotation (310b, 510b) ; et
une structure d'arrêt (348) comprenant une pluralité de billes d'arrêt (346) et un ressort disposé entre la pluralité de billes d'arrêt (346), et dans lequel le deuxième support de fixation (340b, 540b) comprend une plaque de réception de structure d'arrêt (345) recevant la structure d'arrêt (348), et le premier support de fixation (340a, 540a) comprend une plaque d'interférence (344) recevant la plaque de réception de structure d'arrêt (345).

13. Dispositif électronique (100, 200) de la revendication 12, dans lequel le premier support de fixation (340a, 540a) comprend un troisième trou de guidage (342a) formé dans la première direction (Z) et un troisième élément coulissant (341a) configuré pour glisser dans le troisième trou de guidage (342a), et le deuxième support de fixation (340b, 540b) comprend un quatrième trou de guidage (342b) formé dans la première direction (Z) et un quatrième élément coulissant (341b) configuré pour glisser dans le quatrième trou de guidage (342b).

14. Dispositif électronique (100, 200) de l'une des revendications précédentes, dans lequel le module de charnière (500) comprend :
une deuxième structure d'arrêt (570a) comprenant au moins un troisième élément élastique (572a) disposé dans un troisième renfoncement de réception (515a) du premier support de rotation (510a) et configuré pour fournir une force élastique au premier élément de verrouillage (520a) dans une deuxième direction (Y) perpendiculaire à la première direction (Z) et une première structure de came (571a) en contact avec le premier élément de renfoncement (520a) ; et
une troisième structure d'arrêt (570b) comprenant au moins un quatrième élément élastique (572b) disposé dans un quatrième renfoncement de réception (515b) du deuxième support de rotation (510b) et fournissant une force élastique au deuxième élément de verrouillage (520b) dans la deuxième direction (Y) et une deuxième structure de came (571b) en contact avec le deuxième élément de verrouillage (520b).

15. Dispositif électronique (100, 200) de la revendication 14, dans lequel le premier élément de verrouillage (520a) comprend une troisième structure de came (526a) faisant saillie dans une troisième direction (-Y) opposée à la deuxième direction (Y) et configurée pour entrer en contact avec la première structure de came (571a), et le deuxième élément de verrouillage (520b) comprend une quatrième structure de came (526b) faisant saillie dans la troisième direction (-Y) et configurée pour entrer en contact avec la deuxième structure de came (571b).
